# EUROPEAN PATENT SPECIFICATION

(11) **EP 2 023 409 B1**
(45) Date of publication and mention of the grant of the patent: **20.12.2017**
(21) Application number: 07742670.8
(22) Date of filing: 27.04.2007
(51) Int. Cl.: H01L 25/075, H01L 33/60, H01L 33/62, F21K 9/00, H01L 33/48

(54) **SEMICONDUCTOR LIGHT EMITTING MODULE AND DEVICE AND METHOD OF MANUFACTURING THE SAME**
HALBLEITERLICHTEMISSIONSMODUL UND -VORRICHTUNG UND HERSTELLUNGSVERFAHREN DAFÜR
MODULE ELECTROLUMINESCENT A SEMI-CONDUCTEUR ET DISPOSITIF ET SON PROCEDE DE FABRICATION

(30) Priority: 28.04.2006 JP 2006126918; 13.10.2006 JP 2006280448; 07.02.2007 JP 2007059186
(43) Date of publication of application: 11.02.2009
(73) Proprietor: Shimane Prefectural Government, Matsue-shi Shimane 690-8501 (JP); Shimane Electronic Imafuku Works Co., Ltd., Kanagi-cho Hamada-shi Shimane 697-0302 (JP)
(72) Inventor: KOMATSUBARA, Satoshi, Matsue-shi, Shimane 690-0816 (JP); UENO, Toshiyuki, Matsue-shi, Shimane 690-0816 (JP); FUKUDA, Kenichi, Matsue-shi, Shimane 690-0816 (JP); FURUTA, Toru, Hamada-shi, Shimane 697-0302 (JP)
(74) Representative: Winter, Brandl, Fürniss, Hübner, Röss, Kaiser, Polte - Partnerschaft mbB
(86) International application number: PCT/JP2007/059235
(87) International publication number: WO 2007/126074

(56) References cited:
- EP-A1- 1 467 414
- EP-A2- 1 502 752
- WO-A1-2006/028073
- JP-A- 10 502 772
- JP-A- 11 163 411
- JP-A- 63 168 372
- JP-A- 2000 183 406
- JP-A- 2004 128 433
- JP-A- 2004 207 367
- JP-A- 2005 005 740
- JP-A- 2005 079 150
- JP-A- 2005 243 744
- JP-A- 2005 277 331
- JP-U- 02 011 360
- US-A1- 2003 076 033
- US-A1- 2004 222 433

## Description

### Technical Field

The present invention relates to a semiconductor light emitting module and device and a method of manufacturing the same, and more particularly, to a semiconductor light emitting module and device and a method of manufacturing the same, which enable high luminance light emission by high power.

### Background Art

In recent years, there have been developed a variety of devices using semiconductor light emitting elements, such as light emitting diodes (LEDs) and the like, having high energy efficiency for emission in a variety of fields. In particular, LEDs for illumination with use of large current, as substitutes for conventional fluorescent lamps and incandescent electric lamps, have attracted great attention, and techniques for overcoming problems of heat generation, which are caused by large current, have been proposed.

For example, a technique for radiating heat with high efficiency, with electrodes directly connected to semiconductor light emitting elements, which generate heat, as heat radiation blocks, has been proposed (for example, see Patent Document 1).

In the meantime, a technique of a semiconductor light emitting unit for illumination, which uses a plurality of semiconductor light emitting elements as a light source and has a constant area close to a surface light source other than a point light source, with high intensity of light radiation, has been proposed (for example, see Patent Document 2).

In addition, a technique of employing silver plating with high reflection efficiency for a LED mount pattern has been proposed, and, particularly for white light, a technique for increasing light emission efficiency with combination of blue or near-ultraviolet LEDs with a fluorescent substance has been proposed (for example, see Patent Document 3).

However, the convention technique of employing an array of plural semiconductor light emitting elements for a light source has a problem of poor efficiency of heat radiation since a substrate or the like is interposed between a heat radiation block and the elements. In addition, a conventional manufacturing method has a problem of high production costs since elements are arranged on a substrate and then a member such as a heat radiation block or the like is combined to the elements.

In addition, since the silver plating is typically carried out after a pattern is formed, enhancement of reflectivity is limited, not a few non-reflecting surfaces occur due to the formation of the pattern, a sliver-plated surface is easily oxidized, and further it is difficult to maintain initial reflectivity due to change of reflectivity with time. In addition, since the content of fluorescent substance or diffusion agent is not uniform, light emitted in a direction with higher content of fluorescent substance or diffusion agent undergoes large light loss depending on direction of light emitted from LEDs, which makes it impossible to increase emission efficiency of light.

US 2004/222433 A1 (MAZZOCHETTE JOSEPH [US] ET AL; 11 November 2004) discloses a LED package, wherein a flat metal base having a ceramic layer thereon, on which a LED is mounted, acts as a light reflector. Bonding pads are formed directly on the ceramic layer and electrically connected to said LED. The metal base is formed by coining to include a concave light reflecting cavity.

EP 1 502 752 A2 (FUJI PHOTO FILM CO LTD [JP]; 2 February 2005) discloses a light source comprising a plurality of LEDs and a metal block providing a heat sink. LEDs are mounted in grooves on said metal block, wherein the surface of said grooves has a reflection coating comprising a metal such as gold, silver or aluminum, and a dielectric, such as silicon dioxide or titanium oxide. The LEDs are electrically connected to printed circuit boards disposed on said metal block.

In consideration of the above-mentioned problems, it is an object of the invention to provide a semiconductor light emitting module and device and a method of manufacturing the same, which are capable of preventing luminance characteristics from being deteriorated even when large current is flown, thereby achieving high luminance, by suppressing temperature from being increased by dissipating heat, which is generated in semiconductor light emitting elements, with high efficiency.

It is another object of the invention to maintain higher reflectivity to obtain uniform white light and increase emission efficiency of light to achieve light emission with high luminance.

[Patent Document 1] Japanese Patent Laid-Open No. 2002-223007
[Patent Document 2] Japanese Patent Laid-Open No. 2002-93206
[Patent Document 3] Japanese Patent Laid-Open No. H10-242513

### Disclosure of the Invention

The invention is defined in claims 1 and 3.

According to another example not forming part of the present invention, there is provided a semiconductor light emitting module including: semiconductor light emitting elements; a heat dissipation block which becomes one electrode to supply power to the semiconductor light emitting elements disposed in contact with a surface of the heat dissipation block; an insulating film which covers any portion of the surface of the heat dissipation block except for the semiconductor light emitting elements and neighborhoods thereof; and a power distribution film which is disposed in contact with any surface of the insulating film, is electrically connected to the semiconductor light emitting elements, and becomes the other electrode to supply power.

Preferably, each of the neighborhoods of the semiconductor light emitting elements has a reflection plate-like shape to reflect and concentrate light emitted from each of the semiconductor light emitting elements.

Preferably, the heat dissipation block has a slit structure such that air convection to promote heat dissipation is not interrupted.

Preferably, the heat dissipation block has holes to produce an air current to promote dissipation of heat from the heat dissipation block.

Preferably, the insulating film and the power distribution film have holes to produce an air current to promote dissipation of heat from the heat dissipation block.

Preferably, one or more sets of power supply terminals are included in one or both of any positions of the heat dissipation block which becomes one electrode to supply power to the semiconductor light emitting elements and the power distribution film which becomes the other electrode to supply the power.

According to another example not forming part of the present invention, there is provided a semiconductor light emitting device including: a semiconductor light emitting module including semiconductor light emitting elements, a heat dissipation block which becomes one electrode to supply power to the semiconductor light emitting elements disposed in contact with a surface of the heat dissipation block, an insulating film which covers any portion of the surface of the heat dissipation block except for the semiconductor light emitting elements and neighborhoods thereof, and a power distribution film which is disposed in contact with any surface of the insulating film, is electrically connected to the semiconductor light emitting elements, and becomes the other electrode to supply power; and a housing including a power source to supply power to the semiconductor light emitting elements, and a supporting means to support the semiconductor light emitting module.

Preferably, the semiconductor light emitting device further includes an illumination hood having a heat dissipation part and being connected to the heat dissipation block.

According to still another example not forming part of the present invention, there is provided a method of manufacturing a semiconductor light emitting module, including the steps of: disposing semiconductor light emitting elements in contact with a surface of a heat dissipation block which becomes one electrode to supply power to the semiconductor light emitting elements; covering any portion of the surface of the heat dissipation block with an insulating film except for the semiconductor light emitting elements and neighborhoods thereof; and disposing a power distribution film in contact with any surface of the insulating film, the power distribution film being electrically connected to the semiconductor light emitting elements and being the other electrode to supply the power.

Preferably, the method further includes the step of manufacturing the heat dissipation block by pressing a metal plate into a waveform shape.

Preferably, the method further includes the step of forming the heat dissipation block by means of an extruded frame member by extruding the heat dissipation block in a direction normal to a surface on which the semiconductor light emitting elements are disposed.

Preferably, the method further includes the step of manufacturing the heat dissipation block by cutting erecting a portion of a metal plate.

According to the invention, there is provided a semiconductor light emitting module including: semiconductor light emitting elements; a high-reflection plate which is formed to reflect light from the semiconductor light emitting elements by depositing a reflection-enhancing film thereon, the semiconductor light emitting elements being disposed in contact with a surface of the high-reflection plate; an insulating film which covers any portion of the surface of the high-reflection plate except for the semiconductor light emitting elements and neighborhoods thereof; and a power distribution film which is disposed in contact with any surface of the insulating film, is electrically connected to the semiconductor light emitting elements, and becomes the other electrode to supply power.

### Brief Description of the Drawings

[Fig. 1] Fig. 1 is a front view showing a structure of a semiconductor light emitting module.
[Fig. 2] Fig. 2 is a front view showing a structure of a semiconductor light emitting module.
[Fig. 3A] Fig. 3A is a view for explaining a method of manufacturing a semiconductor light emitting module using a heat dissipation block prepared by extrusion molding.
[Fig. 3B] Fig. 3B is a view for explaining a method of manufacturing a semiconductor light emitting module using a heat dissipation block prepared by extrusion molding.
[Fig. 3C] Fig. 3C is a view for explaining a method of manufacturing a semiconductor light emitting module using a heat dissipation block prepared by extrusion molding.
[Fig. 4A] Fig. 4A is a view for explaining a method of manufacturing a semiconductor light emitting module using a heat dissipation block prepared by metal plate bending or extrusion molding.
[Fig. 4B] Fig. 4B is a view for explaining a method of manufacturing a semiconductor light emitting module using a heat dissipation block prepared by metal plate bending or extrusion molding.
[Fig. 4C] Fig. 4C is a view for explaining a method of manufacturing a semiconductor light emitting module using a heat dissipation block prepared by metal plate bending or extrusion molding.
[Fig. 5A] Fig. 5A is a view for explaining a method of manufacturing a semiconductor light emitting module using a heat dissipation block prepared by extrusion molding.
[Fig. 5B] Fig. 5B is a view for explaining a method of manufacturing a semiconductor light emitting module using a heat dissipation block prepared by extrusion molding.
[Fig. 5C] Fig. 5C is a view for explaining a method of manufacturing a semiconductor light emitting module using a heat dissipation block prepared by extrusion molding.
[Fig. 6] Fig. 6 is a front view showing a structure of a semiconductor light emitting module.
[Fig. 7] Fig. 7 is a front view showing a structure of a semiconductor light emitting module.
[Fig. 8A] Fig. 8A is a conceptual view showing a semiconductor light emitting module.
[Fig. 8B] Fig. 8B is a conceptual view showing a semiconductor light emitting module.
[Fig. 8C] Fig. 8C is a conceptual view showing a semiconductor light emitting module.
[Fig. 8D] Fig. 8D is a conceptual view showing a semiconductor light emitting module.

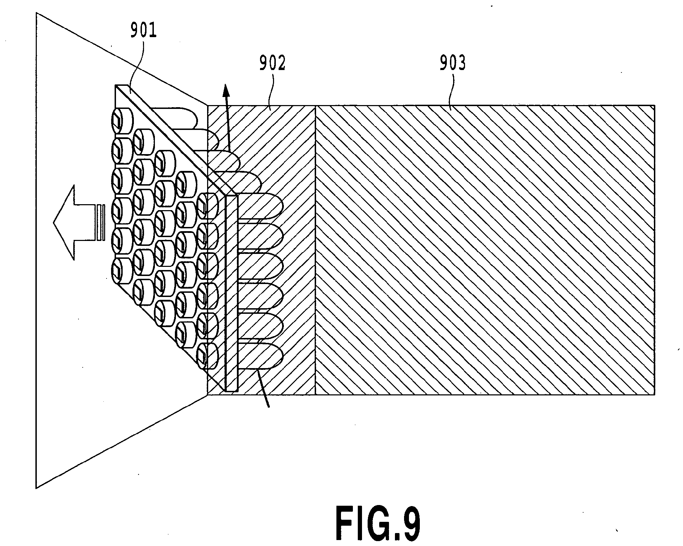

[Fig. 9] Fig. 9 is a schematic view showing an illuminator having semiconductor light emitting modules.
[Fig. 10] Fig. 10 is a view showing feature of heat dissipation in case of use of a conventional semiconductor light emitting module.
[Fig. 11] Fig. 11 is a view showing feature of heat dissipation of a semiconductor light emitting module.
[Fig. 12] Fig. 12 is a view showing a thermal characteristic in case of emission of light from a conventional semiconductor light emitting element for ceiling illumination and in case of emission of light from another semiconductor light emitting module for ceiling illumination.
[Fig. 13] Fig. 13 is a view showing a thermal characteristic in case of emission of light from a conventional semiconductor light emitting element for wall illumination and in case of emission of light from a semiconductor light emitting module for wall illumination according to another example.
[Fig. 14] Fig. 14 is a view showing a thermal characteristic in case of emission of light from a semiconductor light emitting element for ceiling illumination according to a first example.
[Fig. 15] Fig. 15 is a view showing a thermal characteristic in case of emission of light from a semiconductor light emitting element for wall illumination according to a first example.
[Fig. 16A] Fig. 16A is a view for explaining a method of manufacturing a semiconductor light emitting module using a heat dissipation block prepared by cutting and erecting some of a metal plate.
[Fig. 16B] Fig. 16B is a view for explaining a method of manufacturing a semiconductor light emitting module using a heat dissipation block prepared by cutting and erecting some of a metal plate.
[Fig. 16C] Fig. 16C is a view for explaining a method of manufacturing a semiconductor light emitting module using a heat dissipation block prepared by cutting and erecting some of a metal plate.
[Fig. 16D] Fig. 16D is a view for explaining a method of manufacturing a semiconductor light emitting module using a heat dissipation block prepared by cutting and erecting some of a metal plate.
[Fig. 17A] Fig. 17A is a view showing an example of multidirectional heat dissipation fins of a heat dissipation block prepared by cutting and erecting some of a metal plate.
[Fig. 17B] Fig. 17B is a view showing an example of multidirectional heat dissipation fins of a heat dissipation block prepared by cutting and erecting some of a metal plate.
[Fig. 17C] Fig. 17C is a view showing an example of multidirectional heat dissipation fins of a heat dissipation block prepared by cutting and erecting some of a metal plate.
[Fig. 17D] Fig. 17D is a view showing an example of multidirectional heat dissipation fins of a heat dissipation block prepared.by cutting and erecting some of a metal plate.
[Fig. 18] Fig. 18 is a front view showing a structure of a semiconductor light emitting module according to an embodiment of the present invention.
[Fig. 19] Fig. 19 is a partially enlarged front view and a partially enlarged sectional view showing another structure of a semiconductor light emitting module according to an embodiment of the present invention.
[Fig. 20] Fig. 20 is a front view and a cross side view showing another structure of a semiconductor light emitting module according to an embodiment of the present invention.
[Fig. 21] Fig. 21 is a front view and a cross side view showing still another structure of a semiconductor light emitting module according to an embodiment of the present invention.
[Fig. 22] Fig. 22 is a front view and a cross side view showing still another structure of a semiconductor light emitting module according to an embodiment of the present invention.
[Fig. 23] Fig. 23 is a front view and a cross side view showing still another structure of a semiconductor light emitting module according to an embodiment of the present invention.
[Fig. 24] Fig. 24 is a view showing an example of a case of a semiconductor light emitting module according to an embodiment of the present invention.
[Fig. 25A] Fig. 25A is a view showing a conventional configuration for explanation of an effect which does not exist in the prior art in case where an exemplary method of an embodiment of the present invention is employed.
[Fig. 25B] Fig. 25B is a view showing a configuration of an embodiment of the present invention for explanation of an effect which does not exist in the prior art in case where an exemplary method of the embodiment of the present invention is employed.
[Fig. 26] Fig. 26 is a view showing a result of measurement of luminance using materials of three kinds of reflection plates in order to check an effect of the present invention.
[Fig. 27] Fig. 27 is a view for explaining suppression of attenuation of the amount of reflected light after repetition of reflection with increase of reflectivity of a reflection plate according to an embodiment of the present invention.
[Fig. 28] Fig. 28 is a view showing a deployed reflection structure according to an embodiment of the present invention.
[Fig. 29A] Fig. 29A is a view showing a result of test for change of emission efficiency with time according to an embodiment of the present invention.
[Fig. 29B] Fig. 29B is a view showing a result of test for change of emission efficiency with time according to an embodiment of the present invention.
[Fig. 29C] Fig. 29C is a view showing a result of test for change of emission efficiency with time according to an embodiment of the present invention.

### Best Mode for Carrying Out the Invention

Hereinafter, examples and embodiments will be described in detail with reference to the drawings. In the following, the term "embodiment" will be used not only for embodiments of the present invention, which comprise all features of the invention as defined in claims 1 and 3, but also for examples useful for understanding the invention.

### (Structure of Semiconductor Light Emitting Module)

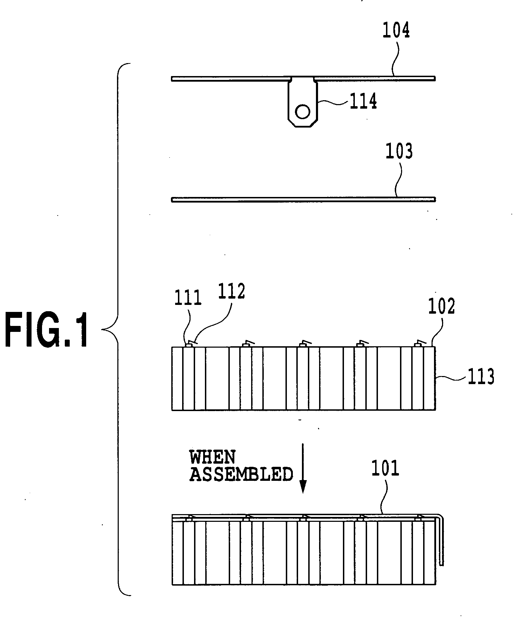

Fig. 1 is a front view showing a structure of a semiconductor light emitting module according to an embodiment. A semiconductor light emitting module 101 according to this embodiment includes heat dissipation blocks 102 for heat dissipation and also acting as one electrode, an insulating film 103 covering the heat dissipation blocks 102 for insulation, and a power distribution film 104 which is additionally laminated via the insulating film 103 and also acts as another electrode. One terminal of each of semiconductor light emitting elements 111 through which current flows for emission of light is electrically and directly connected to the heat dissipation blocks 102 and the other terminal of each of them is connected to the power distribution film 104 via a corresponding conductive wire 112.

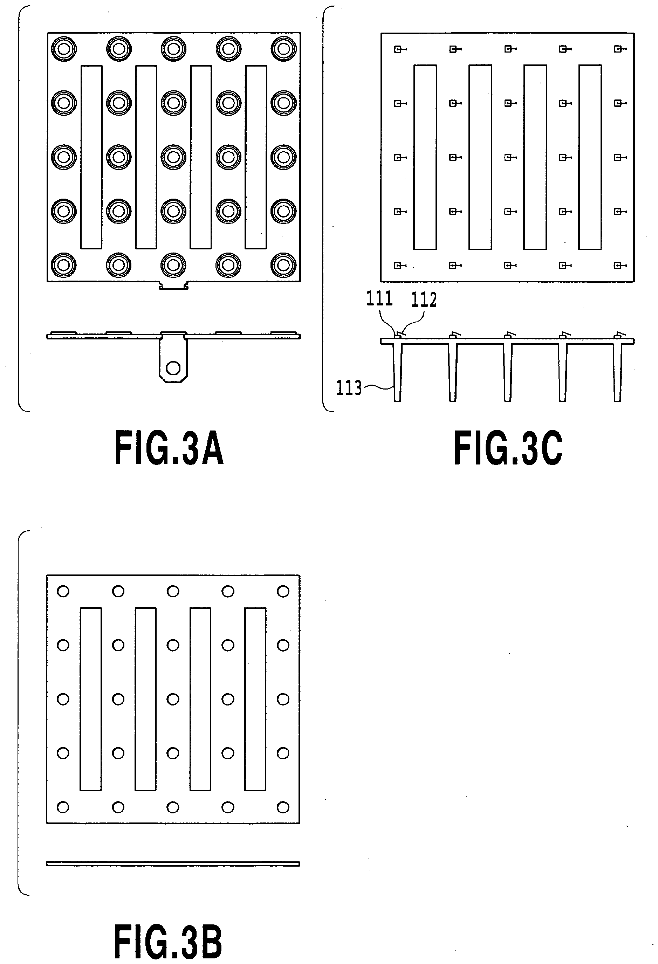

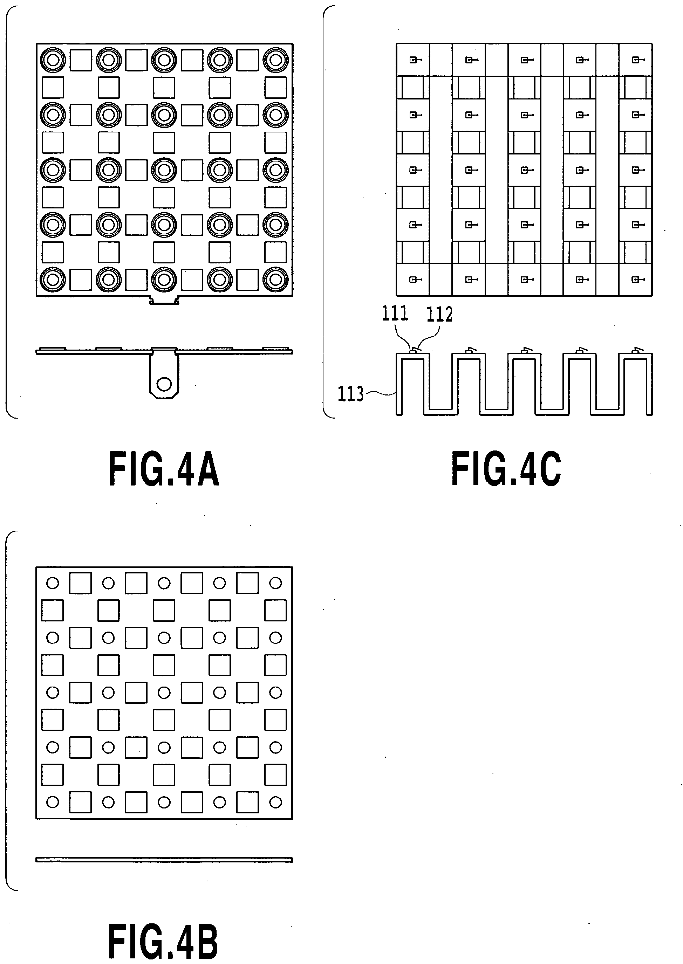

The heat dissipation blocks 102 may be made of any materials and may have any shape as long as they have a heat dissipation property for heat dissipation media and an electrical property for an electrode. For example, in this embodiment, the heat dissipation blocks 102 may be made of metal such as iron, silver, copper, aluminum or the like, alloy thereof, a carbon-based material having thermal conductivity higher than that of metal, or a compound material thereof in various manners. Also, for example, the heat dissipation blocks 102 may have a shape like projecting heat dissipation fins as shown in Figs. 3A to 3C, a slit shape which does not obstruct air convection promoting heat dissipation, or a shape like a waveform when viewed in a horizontal direction as shown in Figs. 4A to 4C. In addition, as will be described later, the heat dissipation blocks may be worked and shaped by an extruded frame member, or may be prepared by metal plate bending, or may be formed using any appropriate methods known in the art.

In addition, in order to more effectively achieve the heat dissipation, the heat dissipation blocks 102 may have vents as shown in Figs. 3A to 3C or the waveform as shown in Figs. 4A to 4C to allow an air current to flow. In this case, the insulating film 103 and the power distribution film 104 has corresponding vents in compliance with such a structure.

In addition, the heat dissipation blocks 102 themselves are prepared to have the function of the heat dissipation fins 113, but without being limited thereto, they may be prepared to be integrated with separately-prepared heat dissipation fins 113 for the reason of manufacture. In addition, it is preferable that places of the heat dissipation blocks 102 where the semiconductor light emitting elements 111 are connected to the heat dissipation blocks 102 are subjected to surface plating known in the art. In addition, the material of the separately-prepared heat dissipation fins 113 does not necessarily have the electrical property for the above-described electrode, but may be, for example, ceramics or plastics.

The insulating film 103 may be any insulating film known in the art as long as it can provide electrical isolation between at least the heat dissipation blocks 102 and the power distribution film 104 and has holes through which light emitted from at least the semiconductor light emitting elements 111 are emitted to the outside. For example, a substrate made of FR4 or polyimide having a shape as shown in Fig. 3B may be interposed between the power distribution film 104 and the heat dissipation blocks 102 to form the insulating film 103, or the power distribution film 104 and the heat dissipation blocks 102 are adhered to each other by means of an adhesive having an insulation property to form an insulating layer, that is, the insulating film 103.

The power distribution film 104 may be, for example, a worked metal plate as shown in Fig. 3A, or a metal film formed by plating the insulating film 103 formed on or attached to the heat dissipation blocks 102 as long as it is formed to provide an electrode having polarity different from that of the heat dissipation blocks 102 of the semiconductor light emitting elements 111. When the power distribution film 104 is prepared by the metal plate, penetration holes have to be provided in portions corresponding to the top side of the semiconductor light emitting elements 111 such that the light emitted from at least the semiconductor light emitting elements 111 are not interrupted. In this case, the shape and size of the penetration holes are determined by any method known in the art. In addition, when the power distribution film 104 is provided by the plating, a metal film is formed by any appropriate method known in the art in such a manner that it has penetration holes while covering the insulating film 103.

Of course, it is also possible to form the insulating film 103 and the power distribution film 104 using a typical print board.

After forming the power distribution film 104, the semiconductor light emitting elements 111 and the power distribution film 104 are electrically connected by the conductive wires 112, and power supplied from a power source through a terminal 114 provided at a portion of the power distribution film 104 is supplied to one pole of each of the semiconductor light emitting elements 111 through the conductive wires 112. It is shown in this embodiment that the semiconductor light emitting elements 111 and the power distribution film 104 are interconnected by the conductive wires 112, however, without being limited thereto, various other method may be used to electrically connect the power distribution film 104 with the semiconductor light emitting elements 111 while forming the power distribution film 104 without using the conductive wires 112. For example, with plating using an insulating film having an appropriate shape, it is possible to form a metal film in compliance with the shape and connect the metal film with the semiconductor light emitting elements 111. In addition, the shape and structure of the terminal 114 may be any shape and structure known in the art, and may be attached, as a separate part, to the power distribution film 104.

In addition, it is preferable that the place of the power distribution film 104 where the conductive wires 112 are connected to the power distribution film 104 is subjected to surface plating known in the art.

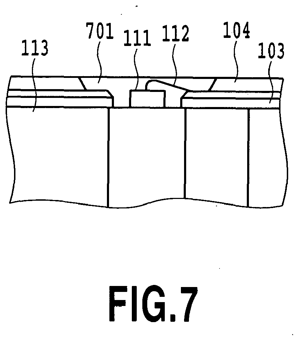

The penetration holes provided in the power distribution film 104 may have any shape as long as they do not obstruct the light emitted from the semiconductor light emitting elements 111. For example, the penetration holes may be formed to concentrate light by employing a reflecting plate-like shape as can be understood from a sectional view shown in Fig. 7. In this case, it is possible to easily seal resin or the like into the penetration holes in order to protect the semiconductor light emitting elements 111.

In addition, in order to concentrate light by putting the shape of the penetration holes provided in the above-described power distribution film 104 into the reflection plate-like shape, it is possible to combine separately-prepared parts having the function of reflection plate with the power distribution film 104. In this case, by making the parts having the function of reflection plate conductive, it is possible to connect the parts with the above-described conductive wires 112.

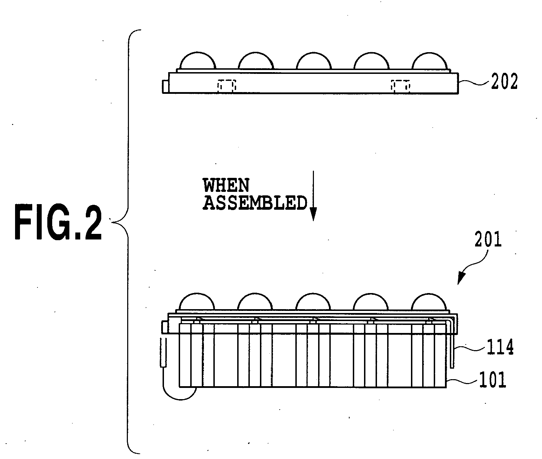

Although the basic structure of the semiconductor light emitting module 101 according to this embodiment has been illustrated in the above with reference to Fig. 1, the light emitted from the semiconductor light emitting elements 111 may be concentrated by covering the semiconductor light emitting module 101 with a case 202 in actuality, as shown in Fig. 2. The case 202 may be made of material such as polycarbonate, acryl, or glass, but without being limited thereto, may be made of any material known in the art and may have any shape. In addition, if the use of the case 202 provides sufficient protection for the semiconductor light emitting module, the above-mentioned resin or the like may not be sealed.

### (Method of Manufacturing Semiconductor Light Emitting Module)

A method of manufacturing the semiconductor light emitting module as constructed above will be described with reference to Figs. 3 to 5. Modules shown in Figs. 3 to 5 each represent a power distribution film, an insulating film and heat dissipation blocks. For example, the power distribution film, the insulating film and the heat dissipation blocks are shown in the form of a top view and a front view in Figs. 3A, 3B and 3C, respectively.

### (Manufacturing Method Example 1)

A manufacturing method Example 1 according to this embodiment will be first described with reference to Figs. 3A to 3C. Figs. 3A to 3C are views for explaining a method of manufacturing a semiconductor light emitting module using heat dissipation blocks prepared by extrusion molding according to this embodiment. Fig. 3C shows heat dissipation blocks provided by subjecting them to extrusion molding and then by forming vents by perforating process, where heat dissipation fins 113 are arranged in parallel to each other. Since the heat dissipation fins 113 are arranged in parallel to each other, when the semiconductor light emitting module is disposed in such a manner that the heat dissipation fins 113 are vertically placed, air heated by the heat dissipation is raised along grooves of the fins, and thus convection of air having lower temperature, which is supplied from a lower side, occurs naturally, which results in promotion of heat dissipation.

In addition, when the semiconductor light emitting elements are disposed to face downward like an illuminator installed on a ceiling or the like, air heated by the heat dissipation fins 113 increases, but convection of new air having lower temperature occurs due to the above-mentioned vents, which also results in promotion of heat dissipation.

Next, a substrate made of material such as FR4, polyimide having a shape as shown in Fig. 3B is prepared as the insulating film. When the substrate is prepared, holes are formed in portions of the semiconductor light emitting elements 111 and portions of vents of the heat dissipation blocks. The prepared substrate is laminated on the above-described heat dissipation blocks. The substrate may be laminated by any adhesion or lamination method known in the art.

In addition, the power distribution film is formed by pressing a metal plate in the shape shown in Fig. 3A. At this time, holes are formed in the power distribution film as the insulating film, and a terminal to be connected to a power source is formed in the power distribution film. In this case, penetration holes corresponding to the top side of the semiconductor light emitting elements may have a concave mirror-like shape as shown in Fig. 7, thereby concentrating light and thus increasing luminance.

The semiconductor light emitting elements 111 are directly placed on the heat dissipation blocks through the penetration holes of the prepared power distribution film. One side of each of the conductive wires 112 is combined to each of the semiconductor light emitting elements 111 and the other side of each conductive wire 112 is combined to an appropriate site near the penetration holes of the power distribution film. Although the semiconductor light emitting elements are disposed after laminating the power distribution film in this embodiment, the semiconductor light emitting elements may be first disposed on the heat dissipation blocks.

Although the semiconductor light emitting module as prepared above has its own essential function in that state, material 701, such as resin or the like, known in the art is sealed into the penetration holes exposed to the outside in order protect the elements, as shown in Fig. 7. Herein, the material 701 used for sealing may be silicon, epoxy or the like.

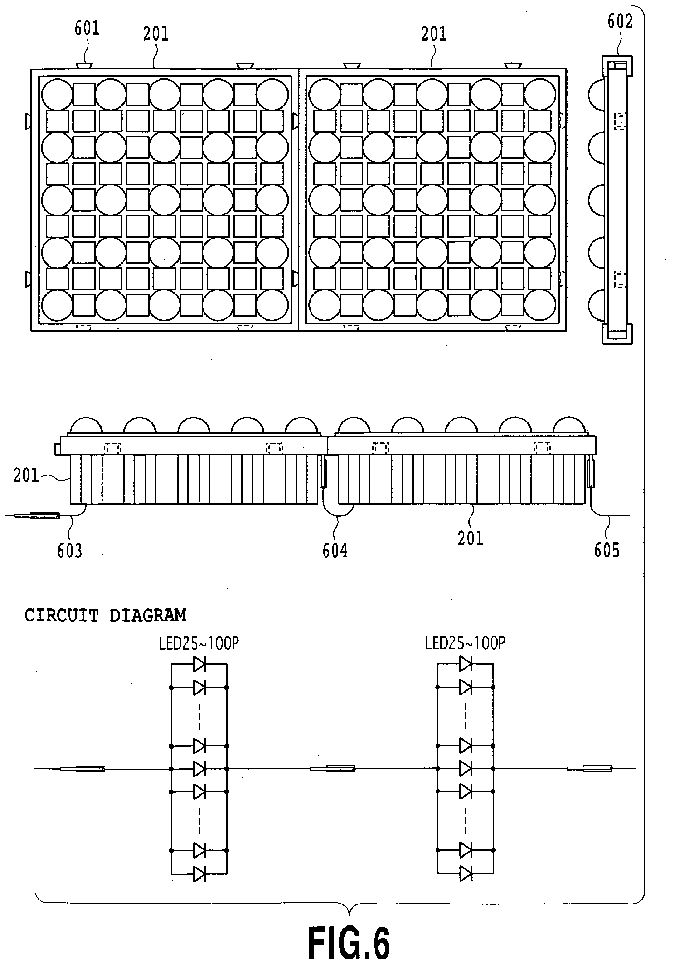

While the semiconductor light emitting module is manufactured according to the manufacturing method Example 1 in this manner, a connection unit using a plurality of semiconductor light emitting modules may be configured by providing the modules with connections 601 interconnecting the modules, as shown in Fig. 6. In this embodiment, by providing the connection unit by interconnecting the modules by means of an electrode terminal 604 other than the connections 601, light may be emitted when the connection unit is connected to a power source. In addition, modules manufactured according the following manufacturing method examples may be interconnected in the same way.

### (Manufacturing Method Example 2)

Next, a manufacturing method Example 2 according to this embodiment will be described with reference to Figs. 4A to 4C. Figs. 4A to 4C are views for explaining a method of manufacturing a semiconductor light emitting module using heat dissipation blocks prepared by metal plate bending or extrusion molding according to this embodiment. Fig. 4C shows heat dissipation fins 113 having a waveform-like shape by bending or extrusion molding. Since the heat dissipation fins 113 are arranged in parallel to each other, when the semiconductor light emitting module is disposed in such a manner that the heat dissipation fins 113 are vertically placed, air heated by the heat dissipation is raised along grooves of the fins, and thus convection of air having lower temperature, which is supplied from a lower side, occurs naturally, which results in promotion of heat dissipation. In addition, the effect obtained when the semiconductor light emitting elements are disposed to face downward is similar to that described above.

Next, the insulating film is formed by applying or coating an adhesive or the like having an insulation property on portions except for the semiconductor light emitting elements 111 on the top side of the heat dissipation blocks according to any method known in the art, as shown in Fig. 4B. By doing so, the insulating film is prevented from being formed in portions corresponding to penetration holes and vents of the heat dissipation blocks.

In addition, an insulating layer may be formed as the insulating film by performing printing having an insulating property and a function of an adhesive.

In addition, the power distribution film may be formed by forging, pressing, cutting or the like a metal plate having a shape as shown in Fig. 4A. Penetration holes and vents of the power distribution film are formed in the same places and with the same shape as in the above manufacturing method example 1. The power distribution film is laminated like the above-described insulating film, and the semiconductor light emitting elements 111 are placed on the power distribution film, and the conductive wires 112 are combined to appropriate places near the penetration holes. The member 701 such as resin or the like is sealed in a way similar to that described above.

### (Manufacturing Method Example 3)

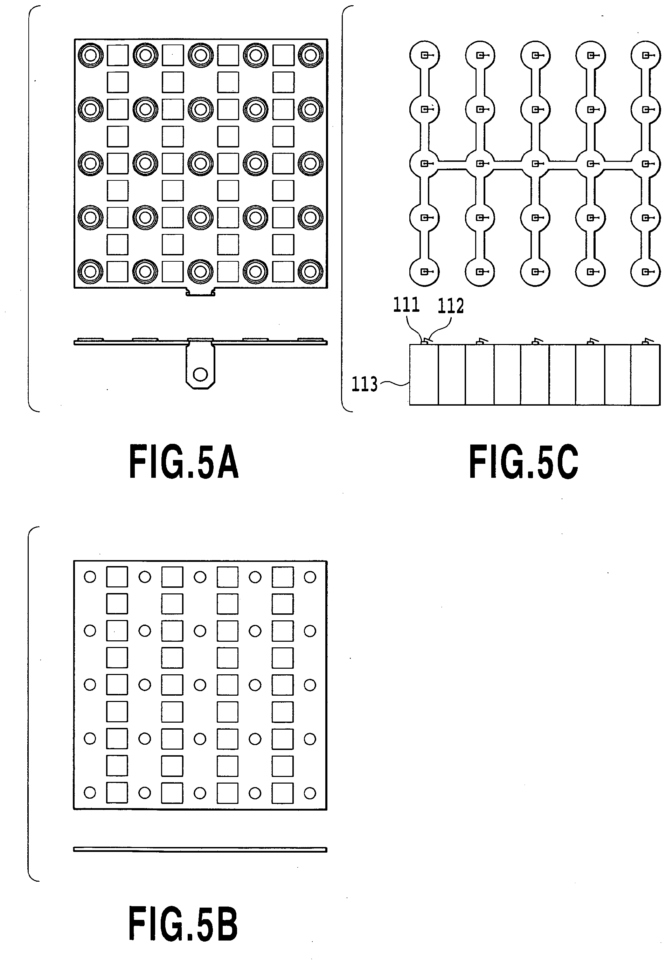

Next, a manufacturing method Example 3 according to this embodiment will be described with reference to Figs. 5A to 5C. Figs. 5A to 5C are views for explaining a method of manufacturing a semiconductor light emitting module using heat dissipation blocks prepared by extrusion molding according to this embodiment. Fig. 5C shows heat dissipation blocks formed by extrusion molding in a normal direction of a loading surface of semiconductor light emitting elements. With such a shape, a process of forming vents after forming the blocks may be omitted. In addition, the effect obtained when the semiconductor light emitting elements are disposed to face downward is similar to that described above.

Next, a substrate is prepared as the insulating film by injection molding or sheet casting according to any method known in the art, as shown in Fig. 5B, and then is laminated on the heat dissipation blocks as in the manufacturing method example 1. In addition, when the insulating film is prepared by the injection molding, by forming bosses in appropriate places on the insulating film and providing through holes in appropriate places of the power distribution film and the heat dissipation blocks, the insulating film can be laminated by thermal caulking alone, in combination of adhesion, or any adhesion or lamination method known in the art, such as insert molding of the insulating film into the power distribution film and the heat dissipation blocks.

In addition, as shown in Fig. 7, the power distribution film is formed by mutually attaching a plurality of metal plates. Penetration holes and vents of the power distribution film are formed in the same places and with the same shape as in the above manufacturing method example 1. The power distribution film is laminated like the above-described insulating film, and the semiconductor light emitting elements 111 are placed on the power distribution film, and the conductive wires 112 are combined to appropriate places near the penetration holes. The member 701 such as resin or the like is sealed in a way similar to that described above.

### (Manufacturing Method Example 4)

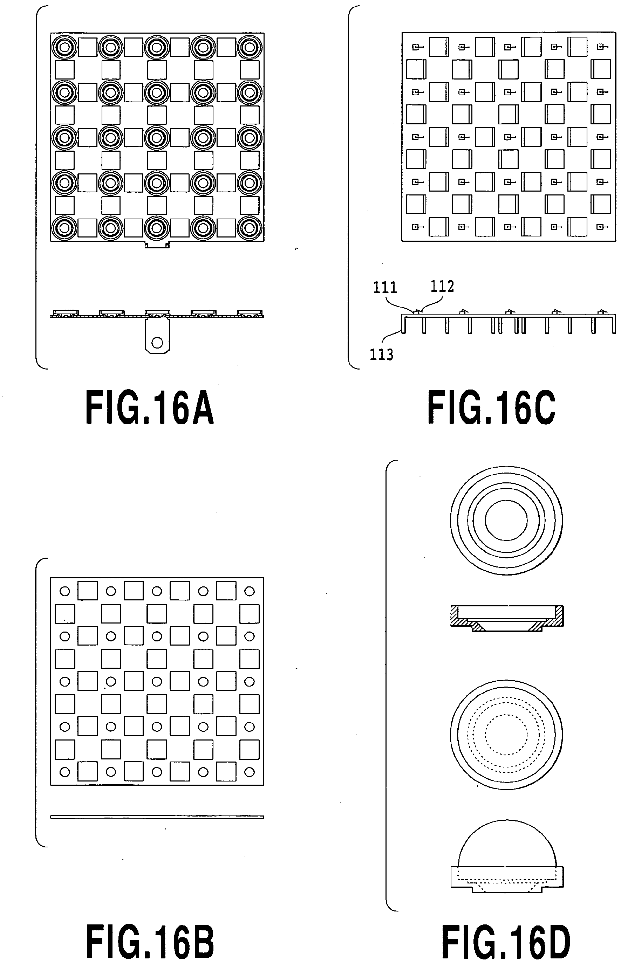

Next, a manufacturing method Example 4 according to this embodiment will be described with reference to Figs. 16A to 16D. Figs. 16A to 16D are views for explaining a method of manufacturing a semiconductor light emitting module using heat dissipation blocks prepared by cutting and erecting some of a metal plate according to this embodiment. Fig. 16C shows heat dissipation blocks formed by cutting and erecting some of a metal plate. When the semiconductor light emitting module is disposed in such a manner that the formed heat dissipation fins 113 are vertically placed, air heated by the heat dissipation is raised along the fins, and thus convection of air having lower temperature, which is supplied from a lower side, occurs naturally, which results in promotion of heat dissipation. In addition, the effect obtained when the semiconductor light emitting module is disposed to face downward is similar to that described above.

The metal plate may be cut and erected by means of a pressing method. Alternatively, the metal plate may be formed by cutting and erecting pin portions by laser cut or etching or any appropriate method known in the art.

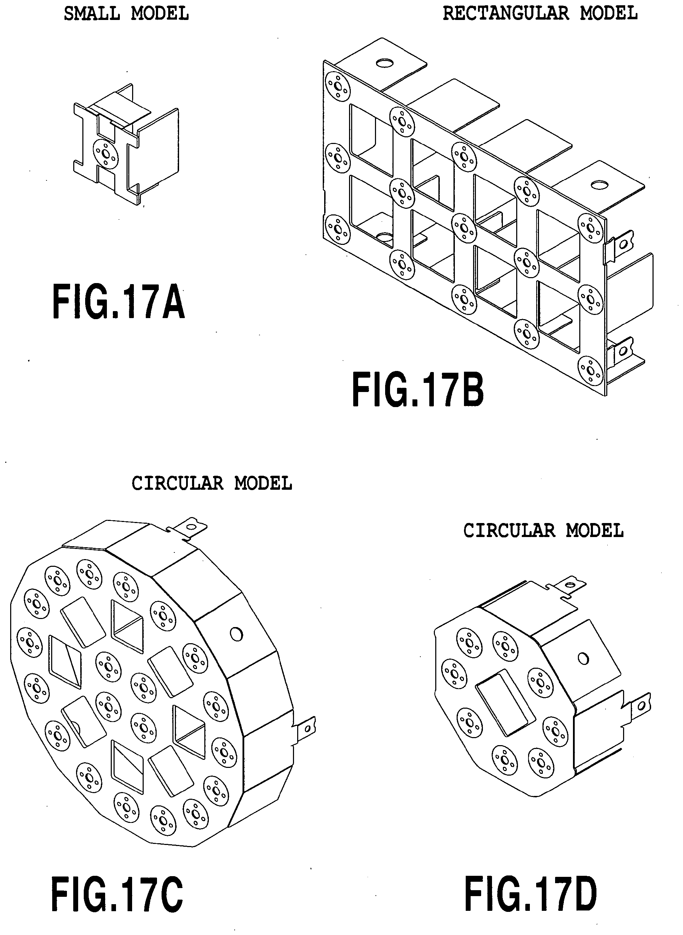

An angle of cutting and erecting is not limited to 90°C, but, for example, the metal plate may be erected in an emission direction of the semiconductor light emitting elements. In addition, the cutting and erecting is not necessarily carried out in an initial step of the process, but may be carried out in the course of disposing the semiconductor light emitting elements or in a final step of the process. In addition, the heat dissipation fins formed by the cutting and erecting do not direct necessarily to the same direction, but, for example, may be formed into a concentric shape in case of a circular product like a circular model shown in Figs. 17C to 17D.

In addition, the holes intended to generate the above-shown and described air current may not be required to be provided depending on the specification of a product, particularly a product including one semiconductor light emitting module or a plurality of semiconductor light emitting modules arranged in a line, or attachment sites or use environments of semiconductor light emitting modules, but the heat dissipation blocks may have a U-like or L-like section for achieving better effects. In addition, although not shown, it is possible to form a terminal connected to a power source like the terminal formed in the above-described power distribution film.

Next, a substrate is prepared as the insulating film by using material, such as polyimide or the like, having a shape shown in Fig. 16B and is then laminated on the heat dissipation blocks as in the manufacturing method example 1.

After such lamination, the power distribution film is formed using a metal plate having a shape shown in Fig. 16A. Here, a portion exhibiting the function of the above-described reflection plate and being shown in Fig. 16D is formed by preparing individual reflecting parts. Material of these reflecting parts may be metal, resin or the like and may be manufactured by any appropriate method known in the art. In this manufacturing method example, the reflecting parts are prepared using metal and are pressed into the power distribution film formed by the metal plate for both of maintenance and conduction. Thereafter, the power distribution film is connected to the semiconductor light emitting elements by means of the conductive wires. Of course, there may be used any appropriate method known in the art such as using resin as material and plating a surface of the resin with conductive material. In addition, a conductive adhesive or the like may be used to fix the power distribution film and the reflecting parts.

Although it has been illustrate in the above that light emitted from the semiconductor light emitting elements 111 is concentrated by covering the semiconductor light emitting module 101 with the case 202, the semiconductor light emitting module 101 is not necessarily covered with an integrated case, but individual semiconductor light emitting elements 111 may be covered with respective cases, as described in this manufacturing method example. Penetration holes and vents of the power distribution film are formed in the same places and with the same shape as in the above manufacturing method example 1. The power distribution film is laminated like the above-described insulating film. The member 701 such as resin or the like is sealed in a way similar to that described above. In addition, it is also possible to further increase a heat dissipation effect by cutting and erecting the power distribution film.

Here, if the manufacturing method example 4 uses a etching process, it is possible to prepare a semiconductor light emitting module with high dimension precision by using and working a laminate of the above-described metal plate, the insulating film and another metal plate.

Hitherto, the four kinds of manufacturing method examples have been described. In any manufacturing method example, it may be preferable that the insulating film is formed in appropriate places of a conductive portion except for the connections of the semiconductor light emitting elements and a supply portion of the power source according to any method known in the art, and one of the manufacturing method examples is selected depending on use purpose and a packaging method of the product. In addition, it is preferable to use material with high thermal conductivity and emissivity for the insulating film.

### (Other Examples of Semiconductor Light Emitting module)

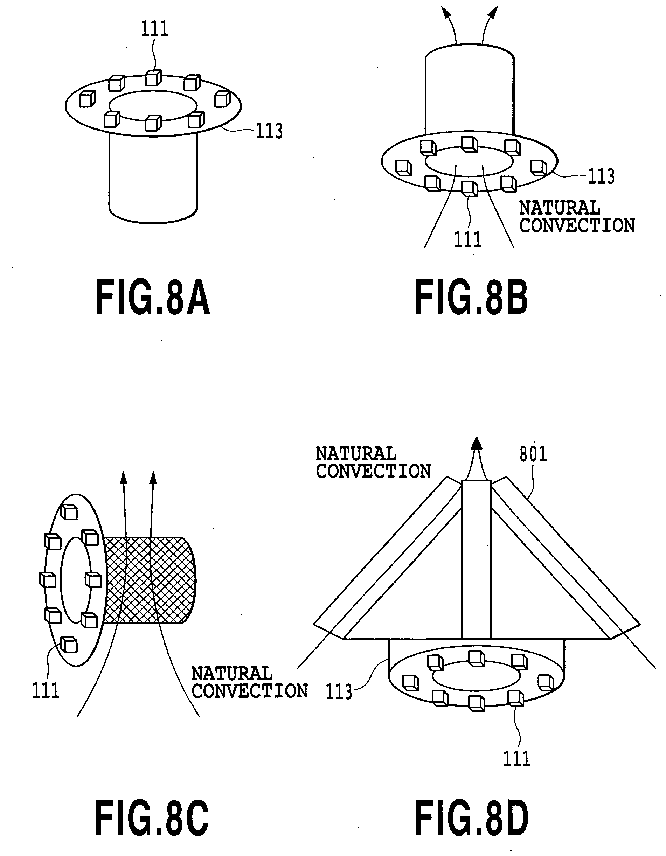

Figs. 8A to 8D are conceptual views showing a structure of a semiconductor light emitting module manufactured according to another embodiment. As shown in Fig. 8A, the semiconductor light emitting elements 111 are placed on a hollow cylindrical heat dissipation block and a semiconductor light emitting module is manufactured as in the above-described manufacturing method examples. Although it is shown in Figs. 8A to 8D that the semiconductor light emitting elements are placed on a doughnut-like portion on the cylindrical heat dissipation block, the semiconductor light emitting elements may be placed without forming such a doughnut-like portion if the cylindrical heat dissipation block is sufficiently thick.

When the semiconductor light emitting module manufactured so is used in a direction shown in Fig. 8B, air heated by heat dissipation goes out of a hollow portion of the cylindrical heat dissipation block, thereby producing natural air convection, which results in promotion of heat dissipation. In addition, as shown in Fig. 8C, by providing a plurality of air vents in the heat dissipation block or making the heat dissipation block in the shape of mesh, natural air convection is produced to promote heat dissipation even when the semiconductor light emitting module is placed in a horizontal direction. In addition, by connecting the heat dissipation block to an umbrella-like portion 801 shown in Fig. 8D, natural convection is produced near the umbrella-like portion 801, which may result in more effective heat dissipation without passing air through the cylindrical heat dissipation block. In this case, since holes are not formed in the top side of the cylindrical heat dissipation block, dusts are prevented from being introduced in the cylindrical heat dissipation block used for an illuminator.

Hitherto, the structure of the semiconductor light emitting modules having different shapes and materials and the method of manufacturing the same have been illustrated. Components such as the heat dissipation block having the shape and material used for these modules may be combined to form different kinds of modules. Accordingly, there is a variety of semiconductor light emitting modules having characteristics of various components. These semiconductor light emitting modules may be used as not only illuminators but also various light emitting materials for signaling and the like.

### (Effects of Semiconductor light Emitting Module)

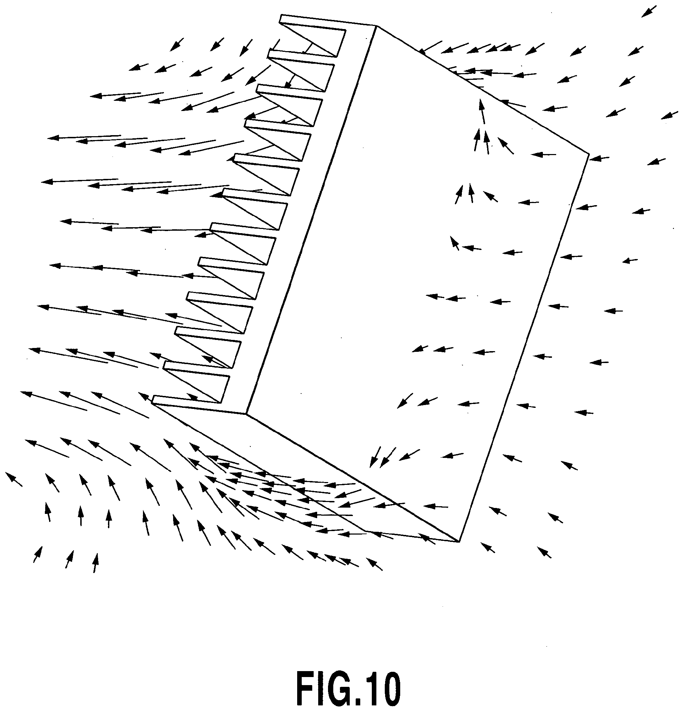

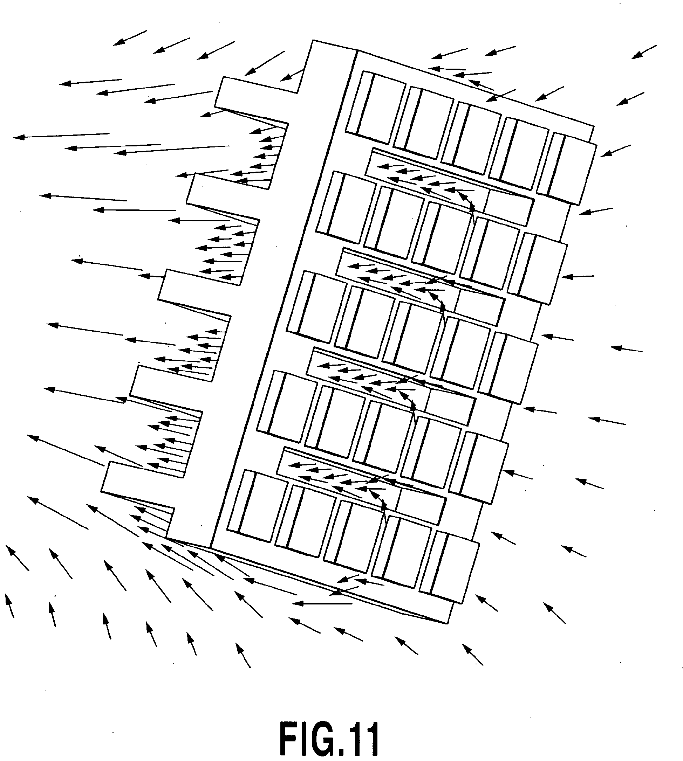

Fig. 10 is a view showing feature of heat dissipation in case of use of a conventional semiconductor light emitting module, and Fig. 11 is a view showing feature of heat dissipation of a semiconductor light emitting module according to an embodiment. Here, the semiconductor light emitting module used for measurement is that manufactured according to the manufacturing method example 1 of the first embodiment, and the measurement is made for the semiconductor light emitting module installed downward for ceiling illumination in Figs. 10 and 11.

In comparison of Fig. 10 with Fig. 11, it can be seen that air convection is produced near the heat dissipation blocks in the semiconductor light emitting module, thereby achieving heat dissipation with high efficiency without collection of heat generated from semiconductor light emitting elements in the module, unlike the conventional semiconductor light emitting module.

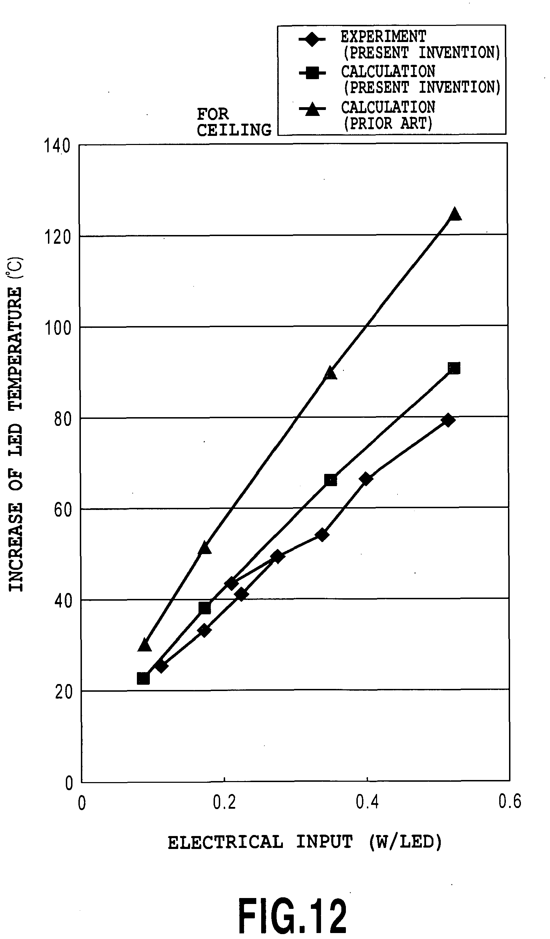

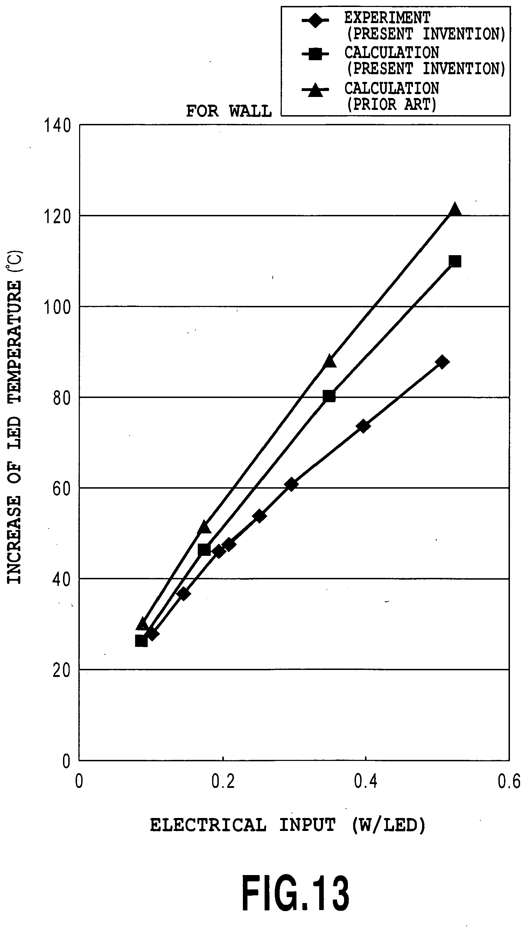

In addition, Figs. 12 and 13 are views showing a thermal characteristic calculated in case of emission of light from a conventional semiconductor light emitting element and in case of emission of light from a semiconductor light emitting module manufactured according to the manufacturing method example 1 of the first embodiment, respectively. Fig. 12 shows the thermal characteristic when the semiconductor light emitting module is used for ceiling illumination and Fig. 13 shows the thermal characteristic when the semiconductor light emitting module is used for wall illumination. As can be seen from Figs. 12 and 13, as compared to a case where the conventional semiconductor light emitting module is used for both of ceiling and wall, the semiconductor light emitting module of the present example for both of ceiling and wall can suppress increase of temperature even when an electrical input (input power) to the semiconductor light emitting module is increased.

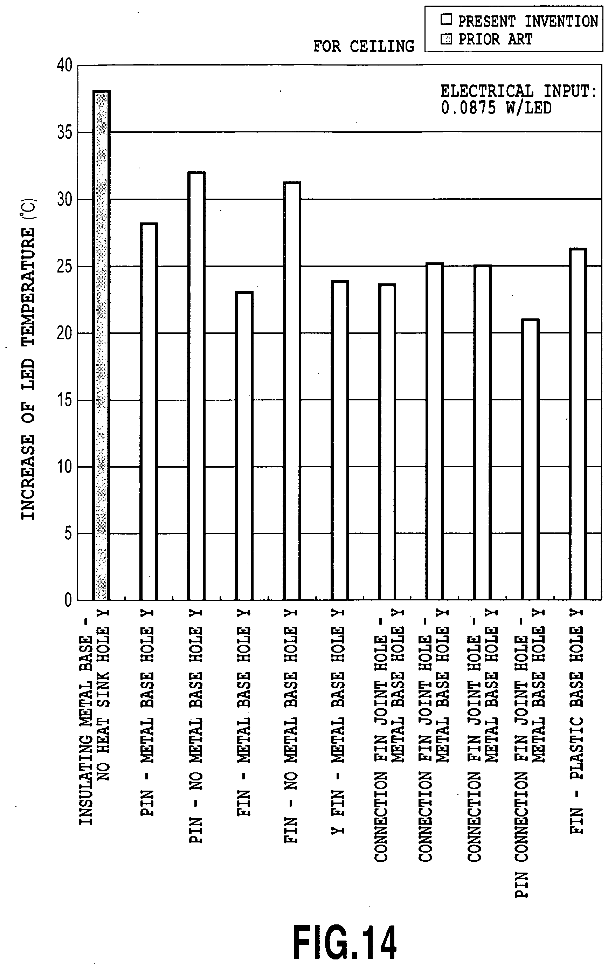

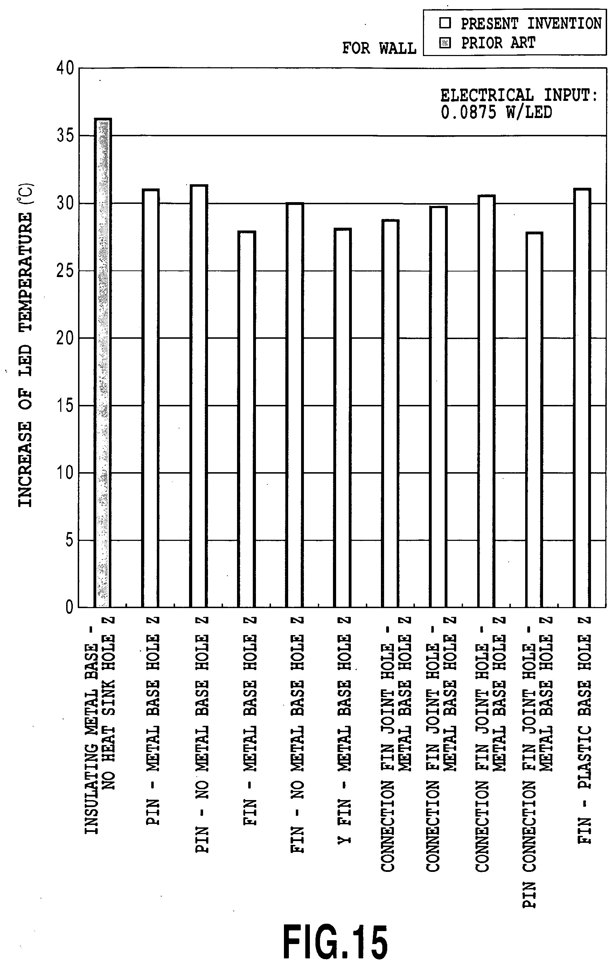

Figs. 14 and 15 are views showing temperature in case of light emission with constant power according to the first embodiment. Fig. 14 shows a simulation for temperature of semiconductor light emitting elements when current is flown to emit light in case where a conventional semiconductor light emitting module is used for ceiling illumination and in case where the semiconductor light emitting modules according to the various embodiments are used for ceiling illumination. Fig. 15 shows a simulation for temperature of semiconductor light emitting elements when current is flown to emit light in case where a conventional semiconductor light emitting module is used for wall illumination and in case where the semiconductor light emitting modules according to the various embodiments are used for wall illumination. As can be seen from Figs. 14 and 15, as compared to the case where the conventional semiconductor light emitting module is used, the semiconductor light emitting modules according to the various embodiments can decrease temperature.

In this manner, since the semiconductor light emitting module is directly formed on the heat dissipation blocks, it is possible to easily manufacture the module, reduce product costs and achieve high luminance emission by large current with highly-efficient heat dissipation.

### (Second Embodiment)

While the above first embodiment can provide highly-efficient heat dissipation of the light emitting module and high luminance by using large current, a second embodiment of the present invention is to provide illumination with high luminance and increase emission efficiency of light by combining a reflecting plate and a fluorescent substance. This second embodiment can be used for not only illuminators but also signals and the like, as illustrated with the light emitting module of the first embodiment, and can show more remarkable effects by itself or in combination of the first embodiment. For example, while simple provision of a reflecting plate or the like in the light emitting module of the first embodiment may deteriorate a heat dissipation characteristic and make it difficult to obtain high luminance, this second embodiment to increase reflectivity allows increase of luminance even with slight decrease of thermal efficiency.

However, in this embodiment, since a reflection-enhancing layer is formed by plating or the like, application of this embodiment to the light emitting module of the first embodiment is limited to that worked using a flat plate such as a pressed metal plate. In addition, since the reflection-enhancing layer of this embodiment is an insulating layer, when a rear side of the module of the first embodiment is used for a light emitting module of an electrode type, the insulating receipt case described in the first embodiment is not required to be used except for a need to remove an appropriate place of the above-described insulating film.

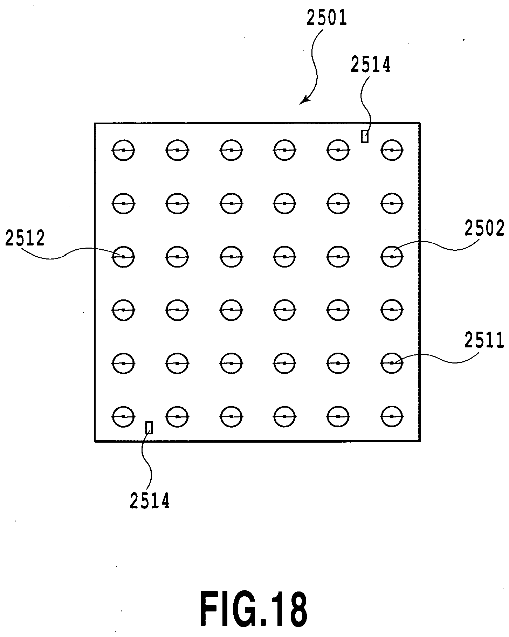

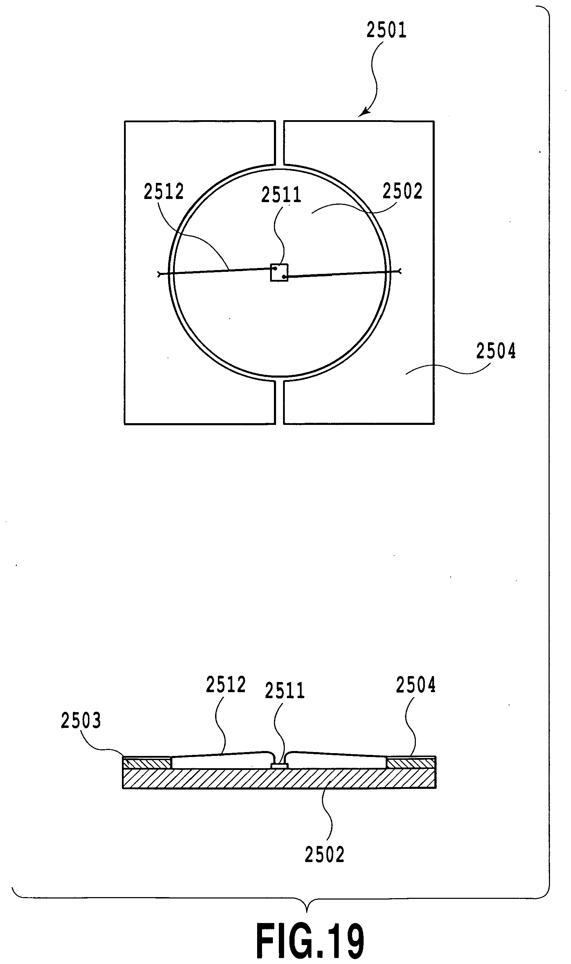

Fig. 18 is a front view showing a structure of a semiconductor light emitting module according to this embodiment, and Fig. 19 is a front view and a sectional view showing enlargement of a portion of the structure.

A semiconductor light emitting module 2501 of this embodiment includes a high-reflection plate 2502 having functions of heat dissipation and light reflection, an insulating film 2503 covering the high-reflection plate 2502, and a power distribution film 2504 laminated via the insulating film 2503 and acting as an electrode. One or more semiconductor light emitting elements 2511 which are actually conducted to emit light are connected to the power distribution film 2504 via conductive wires 2512. With such a structure, it is possible to make the entire mount surface of the semiconductor light emitting elements 2511 highly-reflective. In addition, the power distribution film 2504, which is omitted from the front view of Fig. 18 for the purpose of simplification, has a plus pole and a minus pole, as shown in Fig. 19.

The high-reflection plate 2502 has 95% or more, preferably 98% or more, of the overall reflectivity for sufficient emission of light. For example, the high-reflection plate 2502 may be mounted by forming an adhesive layer on an aluminum base, forming a pure aluminum layer or a pure silver layer thereon, and forming a reflection-enhancing film thereon by depositing titanium oxide or silicon oxide. This reflection-enhancing film allows reduction of deterioration due to oxidation by inner pure aluminum or pure silver, thereby maintaining reflectivity longer than initial reflectivity, which may result in stabilization of product quality.

The high-reflection plate 2502 may be manufactured by forming the reflection-enhancing film on metal finished into a desired shape by, for example, pressing or the like by depositing titanium oxide or silicon oxide on the above-described adhesive layer and pure aluminum layer or pure silver layer, or may be manufactured by forming the reflection-enhancing film on plate-like or coil-like metal and then finishing the film into a desired shape by pressing or the like. An example of this embodiment uses MIRO2-SILVER and MIRO2 available from ALANOD Company, which have 98% and 95% of the overall reflectivity, respectively. The high-reflection plate used in the present invention may be any appropriate reflection plate known in the art as long as it can achieve the object of the present invention, instead of the products available from ALANOD Company. In addition, by connecting the conductive wires 2512 to the high-reflection plate 2502, the high-reflection plate 2502 may be employed as one electrode.

The insulating film 2503 provides electrical isolation between at least the high-reflection plate 2502 and the power distribution film 2504, and may have any appropriate shape known in the art as long as it can include holes through which light emitted from the semiconductor light emitting elements 2511 is transmitted to the outside. For example, the insulating film 2503 may be formed by inserting a substrate made of FR-4, polyimide or the like between the power distribution film 2504 and the high-reflection plate 2502 or by forming an insulating layer by adhering the power distribution film 2504 to the high-reflection plate 2502 by means of an insulating adhesive.

The power distribution film 2504 may be provided by using a worked metal plate as long as it can be formed to provide an electrode for the semiconductor light emitting elements 2511, or by forming a metal film by plating or depositing the insulating film 2503 formed on or attached to the high-reflection plate 2502. When the power distribution film 2504 is prepared by the metal plate, penetration holes or the like have to be provided in the top side of the semiconductor light emitting elements 2511 such that the light emitted from at least the semiconductor light emitting elements 2511 are not interrupted. In this case, the shape and size of the penetration holes are determined by any method known in the art, and therefore, explanation of which will be omitted. In addition, when the power distribution film 2504 is provided by the plating or deposition, a metal film can be formed by any appropriate method known in the art in such a manner that it can form the penetration holes while covering the insulating film 2503. Of course, it is also possible to form the insulating film 2503 and the power distribution film 2504 using a typical print board. These insulating film and power distribution film allow free supply of power in series, in parallel or in combination thereof.

After forming the power distribution film 2504, the semiconductor light emitting elements 2511 and the power distribution film 2504 are electrically connected by the conductive wires 2512. Accordingly, power supplied from a power source through a terminal 2514 provided at a portion of the power distribution film 2504 is supplied to the electrode of the semiconductor light emitting elements 2511 through the conductive wires 2512. In addition, the shape and structure of the terminal 2514 may be any shape and structure known in the art, and, for example, may be soldered with lead electric wires or may be attached, as a separate part, to the power distribution film 2504. In addition, it is preferable that the place of the power distribution film 2504 where the conductive wires 2512 are connected to the power distribution film 2504 is subjected to surface plating known in the art. In addition, it may be also preferable that the semiconductor light emitting elements 2511, the conductive wires 2512 and the surface plating portion are protected by being sealed by resin or the like.

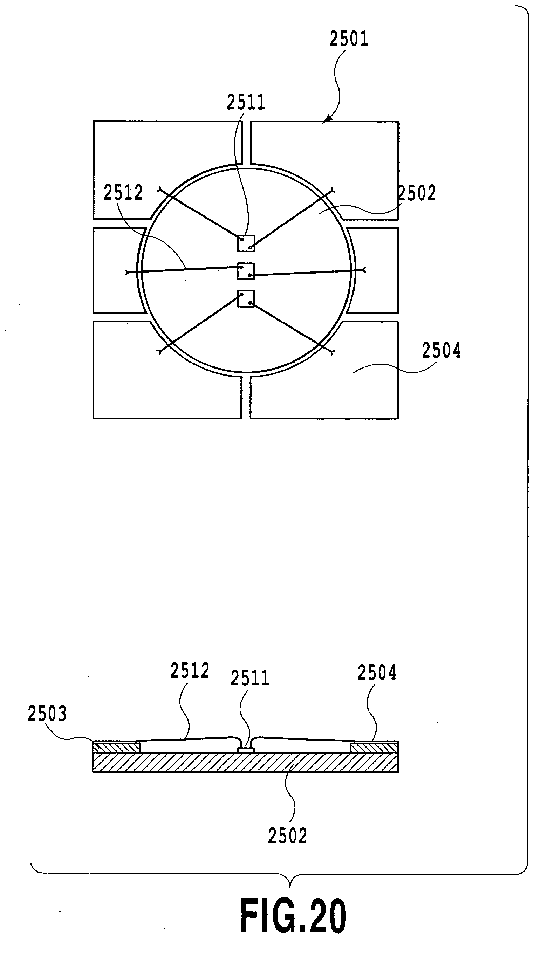

Fig. 20 is a front view and a cross side view showing another structure of a semiconductor light emitting module according to this embodiment. In this example, the amount of light is increased by mounting a plurality of semiconductor light emitting elements 2511 having the same color on one bonding area. With this structure, it is possible to provide full color display by, for example, mounting red, green and blue semiconductor light emitting elements on one bonding area.

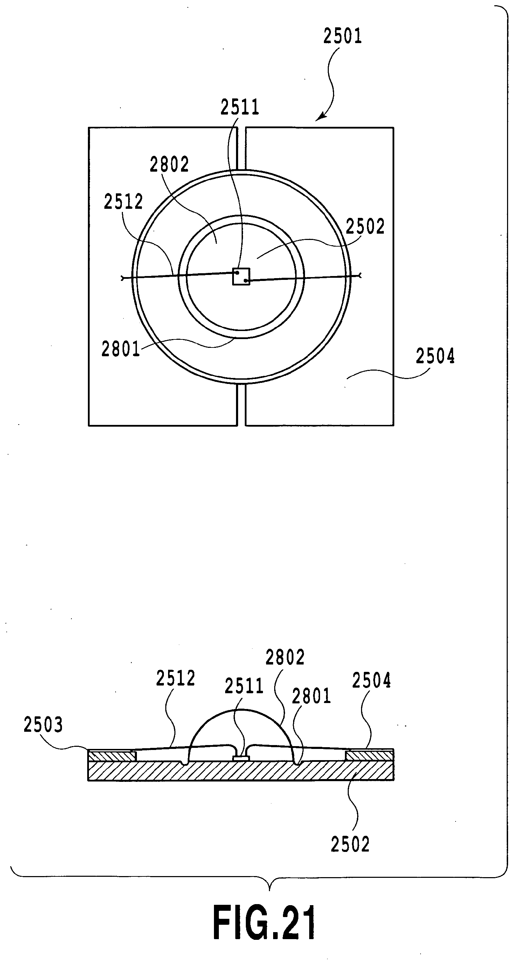

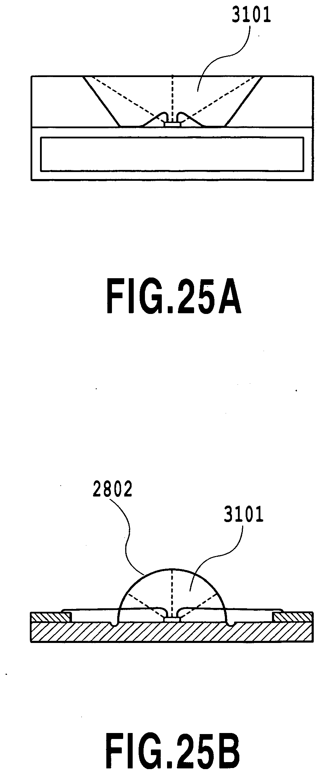

Figs. 21 to 23 are front views and cross side views showing still another structure of a semiconductor light emitting module according to this embodiment. In examples shown in Figs. 21 to 23, by forming a concave groove 2801 surrounding the semiconductor light emitting elements 2511 in the high-reflection plate 2502, it is possible to form a dome 2802 having stable dimension precision using a surface tension when resin containing fluorescent substance or diffusion agent is applied. With the dome 2802 formed in this manner, it is possible to reduce loss of light and hence increase efficiency of light emission, which results in light emission with high luminance, as shown in Fig. 25B, as compared to conventional techniques.

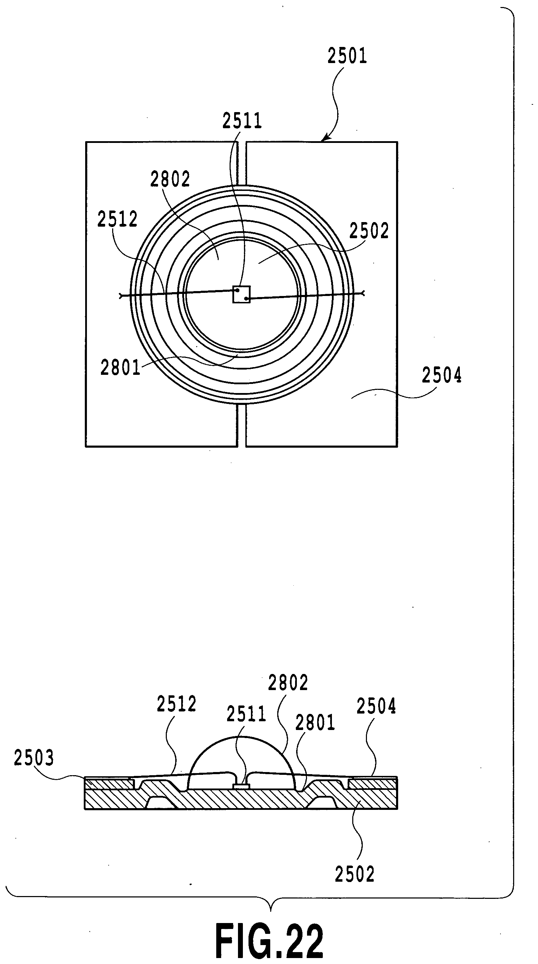

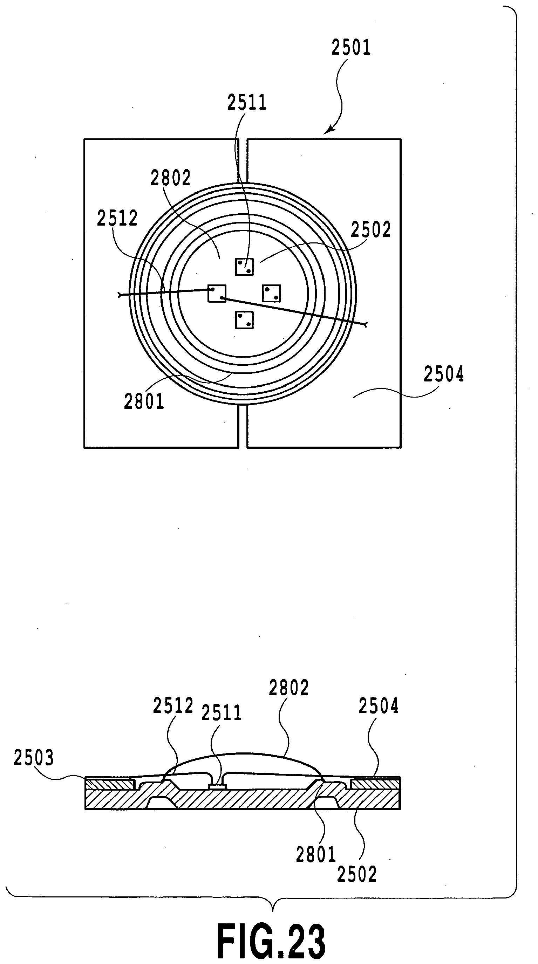

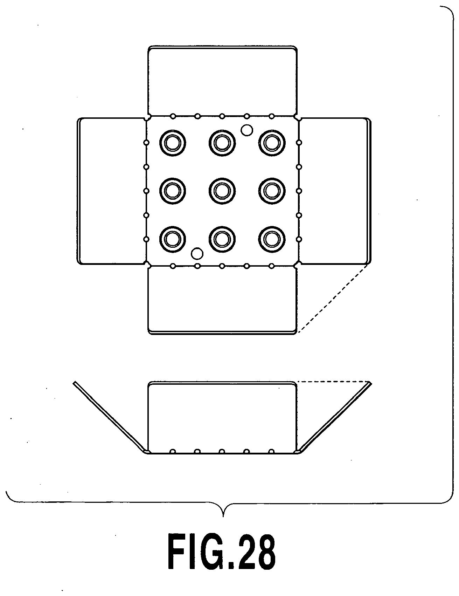

In the example shown in Fig. 22, as can be seen from the cross side view, light can be concentrated by putting a portion of the high-reflection plate 2502 into a reflection plate-like shape. Though this shape can be obtained by, for example, pressing, the reflective structures can also be obtained by metal plate bending. Fig. 28 is a view showing a deployed reflection structure according to this embodiment. Similarly, a semiconductor light emitting module 2501 shown in Fig. 23 includes a plurality of semiconductor light emitting elements 2511 of the semiconductor light emitting module 2501 shown in Fig. 22. As can be seen from Fig. 23, the dome 2802 of a fluorescent layer is not semispherical. This is because less loss of light occurs even if the fluorescent layer is not completely semispherical when the plurality of light emitting elements is used, as compared to when one light emitting element is used. Similarly, when ultraviolet light emitting elements are used, the dome 2802 can be suppressed to be less lowered since there is no need to take a color balance of the light emitting elements and the fluorescent layer.

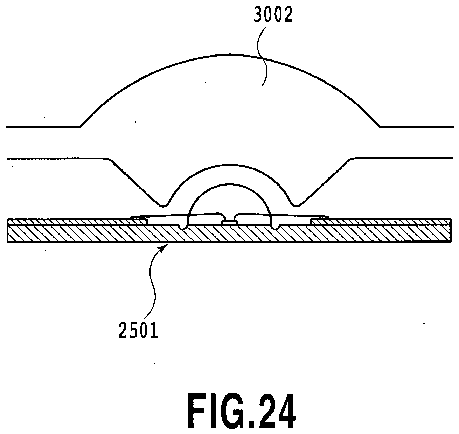

By covering the semiconductor light emitting module 2501 shown in Fig. 22 with a case 3002 shown in Fig. 24, it is possible to further concentrate light emitted from the semiconductor light emitting elements 2511. The case 3002 may be made of polycarbonate, acryl, glass, or any appropriate material known in the art. In addition, if the use of the case 3002 provides sufficient protection for the semiconductor light emitting module, the above-mentioned resin or the like may not be sealed.

Fig. 25B is a view for explaining an effect which does not exist in the prior art in case where the method of this example is employed. With reference to Fig. 25A showing a formation structure of a conventional general fluorescent substance or diffusion agent, since the structure of this example shown in Fig. 25B can make the fluorescent substance or diffusion agent uniform, it is possible to further reduce loss of light as compared to the conventional structure. More specifically, in case of formation structure of the conventional general fluorescent substance or diffusion agent shown in Fig. 25A, it is difficult to obtain uniform white or diffused light since the content of fluorescent substance or diffusion agent is different depending direction of light emitted from the semiconductor light emitting elements 2511. As a result, light emitted in a direction with higher content of fluorescent substance or diffusion agent undergoes light loss so much, which results in decrease of the overall emission efficiency. This means that much of light has to pass through the fluorescent substance or diffusion agent depending on a light path indicated by dotted lines in Fig. 25A in case of the conventional structure. In other words, since a distance by which light emitted upward from the semiconductor light emitting elements 2511 passes through fluorescent substance-containing resin 3101 is apparently different from a distance by which light emitted obliquely from the semiconductor light emitting elements 2511 passes through the fluorescent substance-containing resin 3101, it is understood that light loss occurs.

To overcome the problem caused by such conventional ununiform fluorescent substance or diffusion agent, in this embodiment, as shown in Fig. 25B, the dome 2802 centered at the semiconductor light emitting element 2511 is formed by fluorescent substance or diffusion agent resin such that light passes through the uniform amount of fluorescent substance or diffusion agent irrespective of direction of emission of light. However, fluorescent substance or diffusion agent is generally mixed with resin such as silicon or epoxy, and it is very difficult to form the resin dome 2802 with the uniform amount on a plane around the semiconductor light emitting element 2511.

Therefore, in this embodiment, by forming a circular concave groove 2801 on the high-reflection plate 2502 around the semiconductor light emitting element 2511 and forming the dome 2802 thereon using a surface tension of the resin, a uniform resin layer is formed around the semiconductor light emitting element 2511 such that light passes through the resin by the same distance. The concave groove 2801 may have any size, position and shape as long as it can use a surface tension of the resin and may be formed by, for example, pressing or any appropriate method known in the art.

### (Effects of Semiconductor Light Emitting Module of the Present Invention)

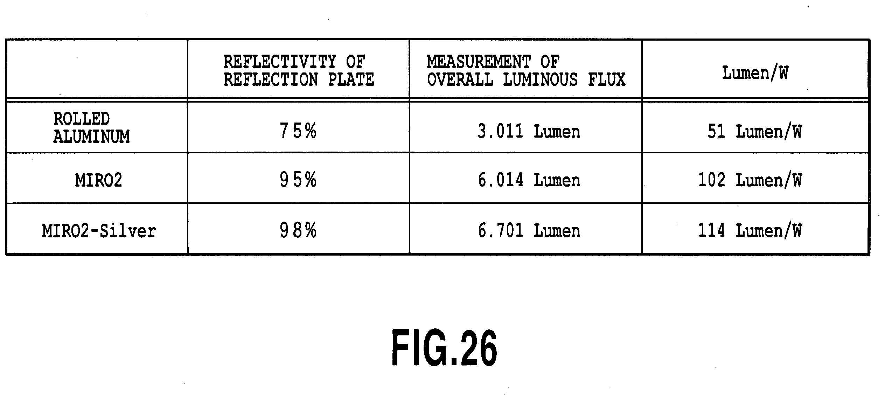

Fig. 26 is a view showing a result of measurement of luminance using a mirror-finished product made by rolled aluminum with 75% of the overall reflectivity, and MIRO2 and MIRO2-Silver available from ALANOD Company as materials of the reflection plate in order to check an effect of the present invention. Here, the semiconductor light emitting elements 2511 having the same characteristic are used as LEDs, a dome is formed using fluorescent substance-containing silicon resin under the same conditions, and an overall luminous flux is measured using an integrating sphere. Referring to Fig. 26, it is understood that MIRO2-Silver can increase emission efficiency two times or more as compared to the conventional rolled aluminum product. A Lumen/Watt value when MIRO2-Silver, is used is 114, which corresponds to emission efficiency about 1.5 times of current market average. This is because the reflectivity of the reflection plate has an effect on emission efficiency.

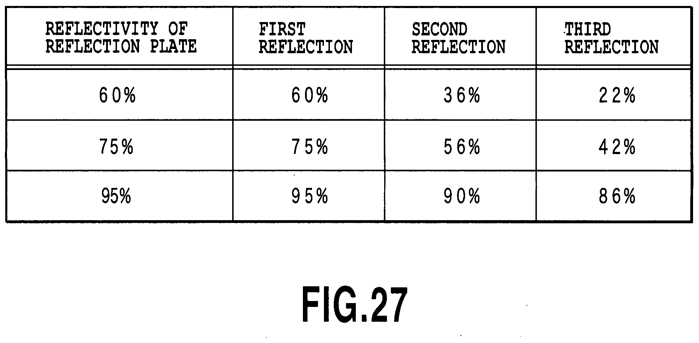

That is, light emitted from the semiconductor light emitting element is irdissipated on fluorescent substance contained in the resin, and a difference in reflectivity of a reflecting surface between original light and excited light, which is caused by repeated reflection in the resin, has a great effect on the emission efficiency. Referring to Fig. 27, it is understood that higher reflectivity of the reflection plate gives attenuation of the amount of reflected light after repeated reflection. Accordingly, it is understood that less attenuation of the reflected light leads to further improvement of emission efficiency.

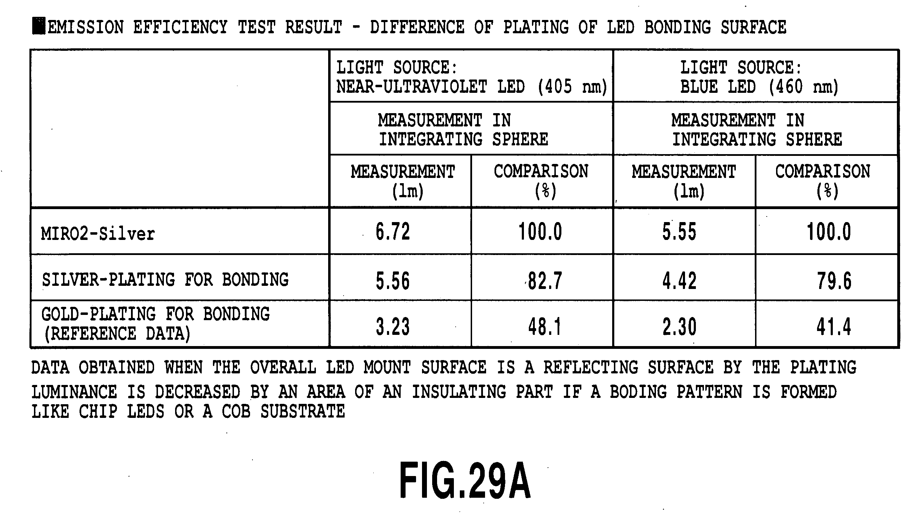

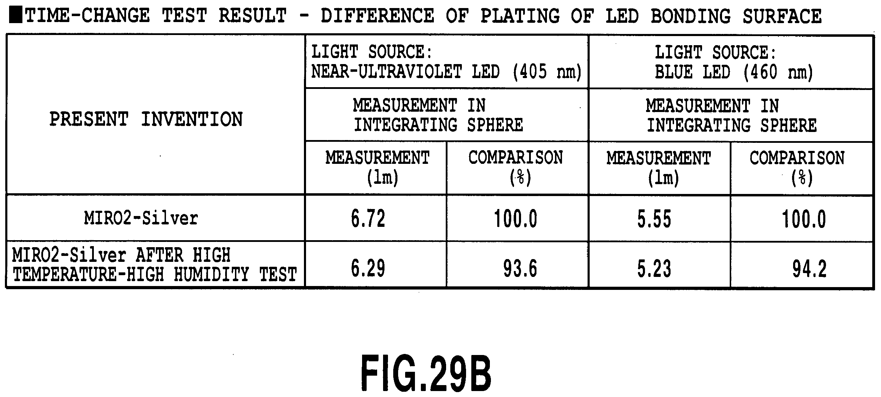

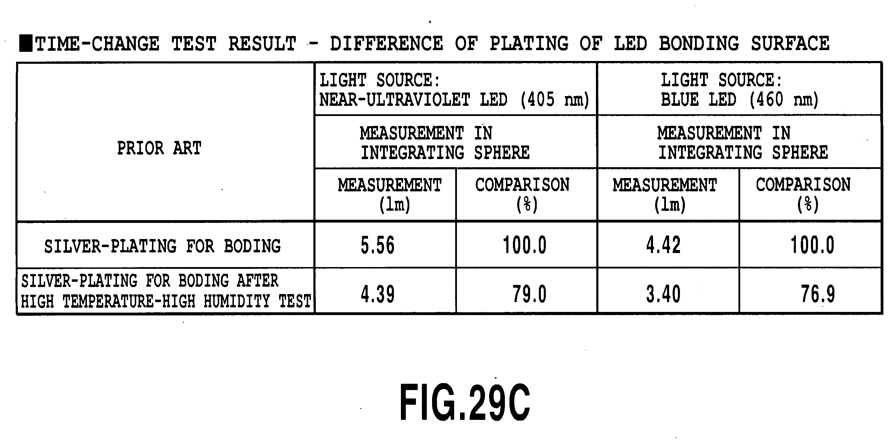

Figs. 29A to 29C are views showing a result of test for emission efficiency according to this embodiment.

The results in Figs. 29A to 29C show how emission efficiency is changed with time. Referring to Figs. 29A to 29C, according to the simulation for change of emission efficiency with time under a high temperature-high humidity test, while the semiconductor light emitting module using MIRO2-Silver maintains 90% of emission efficiency, the emission efficiency of a conventional sliver-plated product is less than 80%. This means that the semiconductor light emitting module maintains initial emission efficiency.

As described above, since the semiconductor light emitting module includes the heat dissipation blocks which become one electrode to supply power to semiconductor light emitting elements arranged in contact with surfaces of the heat dissipation blocks, the insulating film which covers any portions of the surfaces of the heat dissipation blocks except for the semiconductor light emitting elements and the neighborhood thereof, and the power distribution film which is disposed in contact with any surface of the insulating film, is electrically connected to the semiconductor light emitting elements, and becomes the other electrode to supply power, it is possible to provide a semiconductor light emitting module and device and a method of manufacturing the same, which are capable of preventing luminance characteristics from being deteriorated even when large current is flown, thereby achieving high luminance, by suppressing temperature from being increased by dissipating heat, which is generated in the semiconductor light emitting elements, with high efficiency. In addition, it is possible to maintain higher reflectivity to obtain uniform white light and increase emission efficiency of light to achieve light emission with high luminance.

### Industrial Applicability

The present invention relates to a semiconductor light emitting module and device and a method of manufacturing the same, which are capable of achieving light emission with high luminance by high power. According to the present invention, it is possible to provide a semiconductor light emitting module and device and a method of manufacturing the same, which are capable of preventing luminance characteristics from being deteriorated even when large current is flown, thereby achieving high luminance, by suppressing temperature from being increased by dissipating heat, which is generated in semiconductor light emitting elements, with high efficiency.

## Claims

1. A method of manufacturing a semiconductor light emitting module (2501) into which a plurality of semiconductor light emitting elements (2511) are integrally inserted, comprising the steps of:
disposing the plurality of semiconductor light emitting elements (2511) on a high-reflection plate (2502) formed by forming a reflection-enhancing film on a flat metal plate, wherein said reflection-enhancing film is formed by forming a pure aluminum layer or a pure silver layer on said flat metal plate and depositing a titanium oxide film or a silicon oxide film thereon, wherein the plurality of semiconductor light emitting elements (2511) is mounted on a surface of said oxide film, and wherein the mount surface surrounding each of the semiconductor light emitting elements (2511) is a highly-reflective surface of the high-reflection plate (2502), which has a reflectivity of 95% or more for light emitted by the semiconductor light emitting elements (2511); forming an insulating film (2503) on a surface of the reflection-enhancing film of the high-reflection plate (2502), wherein the insulating film has apertures in which the semiconductor light emitting elements (2511) are mounted and through which light emitted from the plurality of semiconductor light emitting elements (2511) is transmitted to the outside; and
forming a power distribution film (2504) which is a metal film on a surface of the insulating film (2503), the power distribution film (2504) being electrically connected to each semiconductor light emitting element (2511) and being an electrode to supply power.

2. The method according to Claim 1, further comprising the step of manufacturing the high-reflection plate (2502) by pressing said metal plate into a shape to reflect and concentrate light emitted from the semiconductor light emitting elements (2511).

3. A semiconductor light emitting module (2501) comprising:
a plurality of semiconductor light emitting elements (2511);
a high-reflection plate (2502) formed to reflect light from the plurality of semiconductor light emitting elements (2511) by forming a reflection-enhancing film on a flat metal plate, wherein said reflection-enhancing film is formed by forming a pure aluminum layer or a pure silver layer on said flat metal plate and depositing a titanium oxide film or a silicon oxide film thereon, wherein the plurality of semiconductor light emitting elements (2511) is mounted on a surface of said oxide film of the reflection-enhancing film, and wherein the mount surface surrounding each of the semiconductor light emitting elements (2511) is a highly-reflective surface of the high-reflection plate (2502), which has a reflectivity of 95% or more for light emitted by the semiconductor light emitting elements (2511); an insulating film (2503) formed on a surface of the reflection-enhancing film of the high-reflection plate (2502) and having apertures in which the semiconductor light emitting elements (2511) are mounted and through which light emitted from the plurality of semiconductor light emitting elements (2511) is transmitted to the outside; and
a power distribution film (2504) which is a metal film formed on a surface of the insulating film (2503), is electrically connected to each semiconductor light emitting element (2511), and is an electrode to supply power.

4. The semiconductor light emitting module (2501) according to Claim 3,
wherein each of the neighborhoods of the semiconductor light emitting elements (2511) has a reflection plate-like shape to reflect and concentrate light emitted from each of the semiconductor light emitting elements (2511).

5. A semiconductor light emitting device, comprising
the semiconductor light emitting module (2501) according to any one of claims 3 to 4, and
a case (3002) protecting the semiconductor light emitting module (2501).

## Patentansprüche

1. Verfahren zum Herstellen eines Halbleiterlichtemissionsmoduls (2501), in das mehrere Halbleiterlichtemissionselemente (2511) einstückig eingefügt sind, wobei das Verfahren die folgenden Schritte aufweist:
Anordnen der Halbleiterlichtemissionselemente (2511) auf einer Hochreflektionsplatte (2502), die durch Ausbilden eines Reflektionserhöhungsfilmes auf einer flachen Metallplatte ausgebildet wird, wobei der Reflektionserhöhungsfilm durch Ausbilden einer reinen Aluminiumschicht oder einer reinen Silberschicht auf der flachen Metallplatte und darauf Abscheiden eines Titanoxidfilmes oder eines Siliziumoxidfilmes ausgebildet wird, wobei die Halbleiterlichtemissionselemente (2511) auf einer Oberfläche des Oxidfilms montiert werden, und wobei die Montageoberfläche, die jedes der Halbleiterlichtemissionselemente (2511) umgibt, eine hochreflektierende Oberfläche der Hochreflektionsplatte (2502) ist, die ein Reflektionsvermögen von 25% oder mehr für Licht, das von den Hatbleiterlichtemissionselementen (2511) emittiert wird, aufweist;
Ausbilden eines Isolierfilms (2503) auf einer Oberfläche des Reflektionserhöhungsfilmes der Hochreflektionsplatte (2502), wobei der Isolierfilm Öffnungen aufweist, in denen die Halbleiterlichtemissionselemente (2511) montiert werden und durch die Licht, das von den Halbleiterlichtemissionselementen (2511) emittiert wird, zur Außenseite durchgelassen wird; und
Ausbilden eines Leistungsverteilungsfilms (2504), der ein Metallfilm ist, auf einer Oberfläche des Isolierfilms (2503), wobei der Leistungsverteilungsfilm (2504) mit jedem Halbleiterlichtemissionselement (2511) elektrisch verbunden ist und eine Elektrode zum Zuführen von Leistung ist.

2. Verfahren nach Anspruch 1, das außerdem den Schritt eines Herstellens der Hochreflektionsplatte (2502) durch Pressen der Metallplatte in eine Gestalt zum Reflektieren und Konzentrieren von Licht, das von den Halbleiterlichtelementen (2511) emittiert wird, aufweist.

3. Halbleiterlichtemissionsmodul (2501), das aufweist:
mehrere Halbleiterlichtemissionselemente (2511);
eine Hochreflektionsplatte (2502), die durch Ausbildung eines Reflektionserhöhungsfilmes auf einer flachen Metallplatte ausgebildet ist, Licht von den Halbleiterlichtemissionselementen (2511) zu reflektieren, wobei der Reflektionserhöhungsfilm durch Ausbilden einer reinen Aluminiumschicht oder einer reinen Silberschicht auf der flachen Metallplatte und darauf Abscheiden eines Titanoxidfilms oder eines Siliziumoxidfilms ausgebildet ist,
wobei die Halbleiterlichtemissionselemente (2511) auf einer Oberfläche des Oxidfilms des Reflektionserhöhungsfilms montiert sind,
und wobei die Montageoberfläche, die jedes der Halbleiterlichtemissionselemente (2511) umgibt, eine hochreflektierende Oberfläche der Hochreflektionsplatte (2502) ist, die ein Reflektionsvermögen von 25% oder mehr für Licht, das von den Halbleiterlichtemissionselementen (2511) emittiert wird, aufweist;
einen Isolierfilm (2503), der auf einer Oberfläche des Reflektionserhöhungsfilmes der Hochreflektionsplatte (2502) ausgebildet ist und Öffnungen aufweist, in denen die Halbleiterlichtemissionselemente (2511) montiert sind und durch die Licht, das von den Halbleiterlichtemissionselementen (2511) emittiert wird, zu Außenseite durchgelassen wird; und
einen Leistungsverteilungsfilm (2504), der ein Metallfilm ist, der auf einer Oberfläche des Isolierfilms (2503) ausgebildet ist, mit jedem Halbleiterlichtemissionselement (2511) elektrisch verbunden ist und eine Elektrode zum Zuführen von Leistung ist.

4. Halbleiterlichtemissionsmodul (2501) nach Anspruch 3,
wobei jede der Nachbarschaften der Halbleiterlichtemissionselemente (2511) eine reflektionsplattenähnliche Gestalt zum Reflektieren und Konzentrieren von Licht, das von jedem der Halbleiterlichtemissionselemente (2511) emittiert wird, aufweist.

5. Halbleiterlichtemissionsvorrichtung, die aufweist:
das Halbleiterlichtemissionsmodul (2501) nach einem der Ansprüche 3 bis 4, und ein Gehäuse (3002), das das Halbleiterlichtemissionsmodul (2501) schützt.

## Revendications

1. Procédé de fabrication d'un module électroluminescent à semi-conducteur (2501) dans lequel une pluralité d'éléments électroluminescents à semi-conducteur (2511) sont intégralement insérés, comprenant les étapes consistant à :
disposer la pluralité d'éléments électroluminescents à semi-conducteur (2511) sur une plaque de réflexion élevée (2502) formée en formant un film d'amélioration de réflexion sur une plaque métallique plate, dans lequel ledit film d'amélioration de réflexion est formé en formant une couche d'aluminium pur ou une couche d'argent pur sur ladite plaque métallique plate et en déposant un film d'oxyde de titane ou un film d'oxyde de silicium sur celle-ci, dans lequel la pluralité d'éléments électroluminescents à semi-conducteur (2511) sont montés sur une surface dudit film d'oxyde, et dans lequel la surface de montage entourant chacun des éléments électroluminescents à semi-conducteur (2511) est une surface de réflexion élevée de la plaque de réflexion élevée (2502), qui a une réflectivité de 95 % ou plus pour la lumière émise par les éléments électroluminescents à semi-conducteur (2511);
former un film isolant (2503) sur une surface du film d'amélioration de réflexion de la plaque de réflexion élevée (2502), dans lequel le film isolant comporte des ouvertures dans lesquelles les éléments électroluminescents à semi-conducteur (2511) sont montés et à travers lesquelles la lumière émise depuis la pluralité d'éléments électroluminescents à semi-conducteur (2511) est transmise vers l'extérieur ; et
former un film de distribution de puissance (2504) qui est un film métallique sur une surface du film isolant (2503), le film de distribution de puissance (2504) étant électriquement connecté à chaque élément électroluminescent à semi-conducteur (2511) et étant une électrode pour fournir de la puissance.

2. Procédé selon la revendication 1, comprenant en outre l'étape consistant à fabriquer la plaque de réflexion élevée (2502) en pressant ladite plaque métallique selon une forme pour réfléchir et concentrer la lumière émise depuis les éléments électroluminescents à semi-conducteur (2511).

3. Module électroluminescent à semi-conducteur (2501) comprenant :
une pluralité d'éléments électroluminescents à semi-conducteur (2511) ;
une plaque de réflexion élevée (2502) formée pour réfléchir de la lumière provenant de la pluralité d'éléments électroluminescents à semi-conducteur (2511) en formant un film d'amélioration de réflexion sur une plaque métallique plate, dans lequel ledit film d'amélioration de réflexion est formé en formant une couche d'aluminium pur ou une couche d'argent pur sur ladite plaque métallique plate et en déposant un film d'oxyde de titane ou un film d'oxyde de silicium sur celle-ci, dans lequel la pluralité d'éléments électroluminescents à semi-conducteur (2511) sont montés sur une surface dudit film d'oxyde du film d'amélioration de réflexion, et dans lequel la surface de montage entourant chacun des éléments électroluminescents à semi-conducteur (2511) est une surface de réflexion élevée de la plaque de réflexion élevée (2502), qui a une réflectivité de 95 % ou plus pour la lumière émise par les éléments électroluminescents à semi-conducteur (2511) ;
un film isolant (2503) formé sur une surface du film d'amélioration de réflexion de la plaque de réflexion élevée (2502) et comportant des ouvertures dans lesquelles les éléments électroluminescents à semi-conducteur (2511) sont montés et à travers lesquelles la lumière émise depuis la pluralité d'éléments électroluminescents à semi-conducteur (2511) est transmise vers l'extérieur ; et
un film de distribution de puissance (2504) qui est un film métallique sur une surface du film isolant (2503), est électriquement connecté à chaque élément électroluminescent à semi-conducteur (2511), et est une électrode pour fournir de la puissance.

4. Module électroluminescent à semi-conducteur (2501) selon la revendication 3, dans lequel chacun des voisins des éléments électroluminescents à semi-conducteur (2511) a une forme de type plaque de réflexion pour réfléchir et concentrer la lumière émise depuis chacun des éléments électroluminescents à semi-conducteur (2511).

5. Dispositif électroluminescent à semi-conducteur, comprenant un module électroluminescent à semi-conducteur (2501) selon l'une quelconque des revendications 3 à 4, et
un boîtier (3002) protégeant le module électroluminescent à semi-conducteur (2501).
